# EUROPÄISCHE PATENTSCHRIFT

(11) **EP 3 830 825 B1**
(45) Veröffentlichungstag und Bekanntmachung des Hinweises auf die Patenterteilung: **19.10.2022**
(21) Anmeldenummer: 19746453.0
(22) Anmeldetag: 24.07.2019
(51) Int. Cl.: G11C 11/22, H01L 27/11502, H01L 27/11585, H01L 29/51, H01L 29/66

(54) **FERROELEKTRISCHE HALBLEITERVORRICHTUNG UND VERFAHREN ZUR HERSTELLUNG EINER SPEICHERZELLE**
FERROELECTRIC SEMICONDUCTOR DEVICE AND METHOD FOR PRODUCING A MEMORY CELL
DISPOSITIF À SEMI-CONDUCTEUR FERROÉLECTRIQUE ET PROCÉDÉ DE FABRICATION D'UNE CELLULE DE MÉMOIRE

(30) Priorität: 31.07.2018 DE 102018212736
(43) Veröffentlichungstag der Anmeldung: 09.06.2021
(73) Patentinhaber: Fraunhofer-Gesellschaft zur Förderung der angewandten Forschung e.V., 80686 München (DE); Christian-Albrechts-Universität zu Kiel, 24118 Kiel (DE)
(72) Erfinder: WAGNER, Bernhard, 25524 Itzehoe (DE); FICHTNER, Simon, 25524 Itzehoe (DE); LOFINK, Fabian, 25524 Itzehoe (DE)
(74) Vertreter: Zimmermann, Tankred Klaus
(86) Internationale Anmeldenummer: PCT/EP2019/069963
(87) Internationale Veröffentlichungsnummer: WO 2020/025426

(56) Entgegenhaltungen:
- CN-A- 105 483 629
- US-A1- 2009 261 395

## Beschreibung

### Technisches Gebiet

Ausführungsbeispiele gemäß der Erfindung beziehen sich auf eine ferroelektrische Halbleitervorrichtung und ein Verfahren zur Herstellung einer Speicherzelle.

### Hintergrund der Erfindung

In integrierten Schaltungen eingesetzte Speicherzellen lassen sich in flüchtige und nicht-flüchtige Prinzipien unterteilen. Auf Seite der flüchtigen Elemente sind dynamische RAM-Bauteile zu nennen (DRAM, dynamic random access memory). Diese verfügen über ein schnelles Schaltverhalten und lassen sich in sehr großer Dichte herstellen. Offensichtlicher Nachteil ist jedoch, dass Informationen nicht dauerhaft gespeichert werden und daher, z.B. nach einem Neustart eines Gerätes, nicht wieder zur Verfügung stehen. Klassische nicht-flüchtige Medien, welches dieses Problem nicht aufweisen, zeigen jedoch deutlich langsamere Schaltzeiten (Zeit welche benötigt wird, um eine Informationseinheit zu schreiben). In diesem Zusammenhang sind elektrische löschbare ROM Bauteile sehr verbreitet (EEPROM, electrically erasable programmable read-only memory). Eine Gruppe von Bauteilen, welche die Vorteile von beiden Ansätzen vereinigen könnte sind Halbleitervorrichtungen mit ferroelektrischen Speicherzellen [31].

Über einen langen Zeitraum wurde von Seiten der Industrie und der Forschung versucht, ferroelektrische Speicherzellen basieren auf Perovskiten wie Blei-Zirkonat-Titanat (PZT) oder Barium-Titanat (BTO) zu realisieren. Wesentliche Hindernisse, welche bis heute kommerziell erfolgreichen Bauteilen verhindert haben, sind dabei eine unbefriedigende Langzeitstabilität sowie fehlende Kompatibilität mit standart-CMOS Prozessen (CMOS: Complementary metal-oxide-semiconductor). Insbesondere das Problem der CMOS-Kompatibilität wurde seitdem durch die Entdeckung von Hafnium-Oxid basierten Ferroelektrika gelöst [32,33]. Es besteht jedoch nach wie vor Verbesserungspotential durch den Einsatz neuer ferroelektrischer Materialien, insbesondere was die Langzeitstabilität der gespeicherten Informationen, auch unter schwierigen Umgebungsbedienungen (z.B. bei hohen Temperaturen) betrifft.

Der Trend zu einer Miniaturisierung von piezoelektrischen Sensoren und Aktuatoren sowie die Einführung von ferroelektrischer Funktionalität in die Integrierte-Schaltung(IC)-Technologie haben zu einem wesentlichen wissenschaftlichen und kommerziellen Interesse an ferroelektrischen Dünnfilmen geführt [1-3]. Viele der bedeutsameren Ferroelektrika sind Perovskitoxide mit typischen Nachteilen wie beispielsweise niedrigen paraelektrischen Übergangstemperaturen, nicht linearen Verschiebungen oder Kompatibilitätsproblemen mit der Komplementärer-Metall-Oxid-Halbleiter(CMOS)-Technologie [2, 4].

US 2009/261395 offenbart eine Speicherzelle mit einer ferroelektrischen Speicherschicht,

In Anbetracht dessen besteht ein Bedarf nach einem Konzept, das einen besseren Kompromiss zwischen zuverlässigem Speichern von Daten mit guter Skalierbarkeit und einer Steigerung der Langzeitstabilität der gespeicherten Informationen bereitstellt.

Diese Aufgabe wird durch die unabhängigen Patentansprüche mit den Vorrichtungsanspruch 1 und den Verfahrensanspruch 14 gelöst.

Erfindungsgemäße Weiterbildungen sind in den Unteransprüchen definiert.

### Zusammenfassung der Erfindung

Ein Ausführungsbeispiel betrifft eine ferroelektrische Halbleitervorrichtung mit einer Speicherzelle, die eine ferroelektrische Speicherschicht und eine erste leitfähige Schicht, die an der ferroelektrischen Speicherschicht angeordnet sein kann, aufweisen kann, und einer Halbleitervorrichtung, die mit der Speicherzelle verbunden sein kann. Die ferroelektrische Speicherschicht der Speicherzelle kann einen Mischkristall mit mindestens einem Gruppe-III-Nitrid und mindestens einem Nicht-Gruppe-III-Element aufweisen,
wobei die nicht Gruppe-III Elemente 20-50% der Plätze von Gruppe-III Atomen der Gruppe-III Nitride innerhalb des Mischkristalls besetzen,

Gemäß einem Ausführungsbeispiel kann die ferroelektrische Speicherschicht eine erste Oberfläche aufweisen, an die die erste leitfähige Schicht angeordnet ist. Somit ist die ferroelektrische Speicherschicht beispielsweise an der ersten Oberfläche mit der ersten leitfähigen Schicht verbunden. Die Speicherzelle kann mit der Halbleitervorrichtung dahin gehend verbunden sein, dass die Speicherzelle an der Halbleitervorrichtung angeordnet ist, ein Teil der Halbleitervorrichtung repräsentiert oder beispielsweise über eine elektrische Verbindung verbunden ist.

Dieses Ausführungsbeispiel der ferroelektrischen Halbleitervorrichtung basiert auf der Erkenntnis, dass durch die Verwendung des Mischkristalls mit dem Gruppe-III-Nitrid und dem Nicht-Gruppe-III-Element in der ferroelektrische Speicherschicht eine hohe Langzeitstabilität der gespeicherten Informationen in der Speicherzelle auch bei hohen Temperaturen gewährleistet werden kann. Zudem kann der Mischkristall ein zuverlässiges Speichern von Daten mit guter Skalierbarkeit in der Speicherzelle ermöglichen, da der Mischkristall eine besonders stabile und gleichzeitig große elektrische Polarisation aufweisen kann.

Somit ist festzuhalten, dass die ferroelektrische Halbleitervorrichtung ein zuverlässiges Speichern mit guter Skalierbarkeit und Langzeitstabilität der gespeicherten Informationen bieten kann, indem die ferroelektrische Speicherschicht der Speicherzelle vorteilhaft mit der Halbleitervorrichtung kombiniert wird.

Gemäß einem Ausführungsbeispiel kann die Speicherzelle eine isolierende Schicht, die ferroelektrische Speicherschicht und die erste leitfähige Schicht aufweisen, die in dieser Reihenfolge angeordnet sind; oder die Speicherzelle kann eine zweite leitfähige Schicht, die ferroelektrische Speicherschicht und die erste leitfähige Schicht aufweisen, die in dieser Reihenfolge angeordnet sind; oder die Speicherzelle kann eine isolierende Schicht, eine zweite leitfähige Schicht, die ferroelektrische Speicherschicht und die erste leitfähige Schicht aufweisen, die in dieser Reihenfolge angeordnet sind. Je nach Anforderung kann somit die Speicherzelle der ferroelektrische Halbleitervorrichtung individuell angepasst werden. Die Speicherzelle kann somit durch den beschriebenen Schichtaufbau eine gute Skalierbarkeit aufweisen. So können die einzelnen Schichten der Speicherzelle beispielsweise eine sehr kleine Schichtdicke von größer als 70 nm, größer als 30 nm, größer als 10 nm oder größer als 1.5 nm aufweisen. Somit kann die Speicherzelle ausgelegt sein, um ein zuverlässiges Speichern, eine gute Skalierbarkeit und eine Langzeitstabilität der gespeicherten Information in der Speicherzelle zu gewährleisten.

Gemäß einem Ausführungsbeispiel kann die ferroelektrische Speicherschicht eine geringere Ausdehnung parallel zu einer Oberfläche der ersten leitfähigen Schicht aufweisen als die isolierende Schicht und/oder die zweite leitfähige Schicht. Die Oberfläche der ersten leitfähigen Schicht kann die Oberfläche darstellen, mit der die erste leitfähige Schicht an die ferroelektrische Speicherschicht angeordnet ist. Somit kann die Oberfläche der ersten leitfähigen Schicht eine verbindende Oberfläche zwischen der ferroelektrischen Speicherschicht und der ersten leitfähigen Schicht darstellen. In anderen Worten kann die ferroelektrische Speicherschicht eine Ausdehnung parallel zu der Oberfläche der ersten leitfähigen Schicht aufweisen, so dass die Isolationsschicht und/oder die zweite leitfähige Schicht über die ferroelektrische Speicherschicht hinausstehen können. Die Ausdehnung kann so gewählt sein, dass an der ferroelektrischen Speicherschicht und/oder der zweiten leitfähigen Schicht anliegende Ladung die isolierende Schicht nicht mit einer elektrischen Spannung über deren Durchbruchspannung belastet. Somit wird z. B. ein zuverlässiges Speichern und Langzeitstabilität der gespeicherten Informationen mit der Speicherzelle gewährleistet.

Gemäß einem Ausführungsbeispiel kann die Speicherzelle eine U-Form, eine O-Form, eine zylindrische Form oder eine Quaderform aufweisen. Dabei kann die U-Form oder die O-Form beispielsweise scharfe Ecken oder abgerundete Ecken aufweisen. Somit wird je nach Anforderung oder je nach Halbleitervorrichtung eine individuelle Ausgestaltung der Speicherzelle gewährleistet. Je nach Halbleitervorrichtung kann somit eine passende Speicherzelle mit der Halbleitervorrichtung verbunden werden. Somit wird eine gute Skalierbarkeit der ferroelektrische Halbleitervorrichtung mit der Speicherzelle erreicht und durch die individuelle Passform der Speicherzelle, anpassbar auf die Halbleitervorrichtung, kann eine optimierte Verbindung zwischen der Halbleitervorrichtung und der Speicherzelle erreicht werden, wodurch ein zuverlässiges Speichern und eine Langzeitstabilität der gespeicherten Informationen in der ferroelektrischen Halbleitervorrichtung erreicht werden kann. Durch die spezielle Form der Speicherzelle kann zudem ein Schaltverhalten der Ferroelektrischen Halbleitervorrichtung sehr schnell und effizient erfolgen.

Gemäß einem Ausführungsbeispiel kann das Gruppe-III-Nitrid des Mischkristalls der ferroelektrischen Speicherschicht AIN, GaN, InN oder eine Kombination dieser aufweisen, wie z. B. AIGaN, AlInN, GaInN oder AlGaInN. Der Mischkristall basierend auf dem Gruppe-III-Nitrid kann eine Polarisation aufweisen, deren Betrag Werte von über 50 µC/cm², 80 µC/cm² oder von über 100 µC/cm² erreichen kann. Umfasst die Halbleitervorrichtung beispielsweise einen FET (z. B. einen planaren MOSFET, einen HEMT, einen FinFET, etc.), so kann die Speicherzelle mit einem Mischkristall mit den oben beschriebenen Gruppe-III-Nitriden, ein besonders effizientes Öffnen und Schließen eines FET-Kanals gewährleisten. Die Kombination aus einem FET und einer ferroelektrischen Speicherzelle kann als FeFET bezeichnet werden. Hierfür kann die Speicherzelle beispielsweise zumindest einen Teil einer Gatestruktur der Halbleitervorrichtung bilden. Umfasst die Halbleitervorrichtung beispielsweise eine RAM-Zelle, so kann die Speicherzelle mit dem Mischkristall mit den oben beschriebenen Gruppe-III-Nitriden, einen besonders großen Unterschied eines Auslesestroms der RAM-Zelle gewährleisten. Hierfür kann die Speicherzelle beispielsweise zumindest einen Teil einer Kondensatorstruktur der Halbleitervorrichtung bilden. Die Gruppe-III-Nitride können zudem eine Kristallisation bereits auf den ersten Nanometern mit einer korrekten Orientierung aufweisen, was eine gute Skalierbarkeit hin zu möglichst dünnen Schichten ermöglicht.

Gemäß einem Ausführungsbeispiel kann das Nicht-Gruppe-III-Element ein Übergangsmetall oder Mg aufweisen. Das Nicht-Gruppe-III-Element kann somit beispielsweise Sc, Y, Nb, Ti oder Mg sein. Das Nicht-Gruppe-III-Element kann eine Ferroelektrizität des Mischkristalls der Speicherzelle gewährleisten. Durch die spezielle Materialkombination des Mischkristalls der Speicherzelle mit dem Nicht-Gruppe-III-Element kann der Mischkristall relevante ferroelektrische Eigenschaften auch bei Temperaturen von über 200°C, 400°C oder 600°C aufweisen. Zudem kann eine Polarisation des Mischkristalls über einen langen Zeitraum ohne messbare Abschwächungen erhalten bleiben.

Alternativ können die Nicht-Gruppe-III-Elemente 25 bis 45 % oder 27 bis 43 % der Plätze von Gruppe-III-Atomen der Gruppe-III-Nitride innerhalb des Mischkristalls besetzen. Durch das spezielle Verhältnis zwischen den Nicht-Gruppe-III-Elementen und den Gruppe-III-Atomen kann eine ferroelektrische Eigenschaft der ferroelektrischen Speicherschicht gewährleistet werden. Ein zunehmender Gehalt an Nicht-Gruppe-III-Elementen innerhalb des Mischkristalls kann ein Koerzitivfeld reduzieren. Somit kann erreicht werden, dass eine Polarisation der ferroelektrischen Speicherschicht mit einem Koerzitivfeld geringer als ein Durchbruchsfeld des Mischkristalls umorientiert werden kann. Ein mittleres Feld, bei dem diese Umorientierung stattfindet, kann als Koerzitivfeld bezeichnet werden. Somit wird beispielsweise mithilfe der Ferroelektrizität ein zuverlässiges Speichern ermöglicht. Mit der speziellen Struktur des Mischkristalls (Verbindung der Gruppe-III-Elemente mit den Gruppe-III-Nitriden) kann eine gute Skalierbarkeit gewährleistet werden und mit der speziellen Materialkombination des Mischkristalls kann zudem eine Langzeitstabilität der gespeicherten Informationen gewährleistet werden.

Gemäß einem Ausführungsbeispiel kann die Halbleitervorrichtung einen FeFET umfassen und die Speicherzelle kann zumindest einen Teil einer Gatestruktur der Halbleitervorrichtung bilden. Hierbei kann eine schaltbare elektrische Polarisation der ferroelektrischen Speicherschicht der Speicherzelle je nach Ausrichtung einen Source-Drain-Kanal des FeFETs schließen bzw. öffnen. Somit kann eine ferroelektrische Halbleitervorrichtung bereitgestellt werden, die ein sehr schnelles Speichern von Informationen ermöglicht. Ein weiterer Vorteil ist eine Langzeitstabilität der gespeicherten Informationen.

Gemäß einem Ausführungsbeispiel kann der FeFET ein planarer MOSFET (metal-oxide-semiconductor field-effect transistor = Metall-Oxid-Halbleiter-Feldeffekttransistor), ein FinFET oder ein HEMT (High-Electron-Mobility-Transistor = Transistor mit hoher Elektronenbeweglichkeit) sein. Somit lassen sich die Vorteile einer ferroelektrischen Speicherzelle in vielfältigen Varianten des FeFETs nutzen. Die einzelnen Varianten (planarer MOSFET, FinFET oder HEMT) können somit zu einem sehr schnellen und langzeitstabilen Speichern von Informationen durch die ferroelektrische Halbleitervorrichtung beitragen.

Gemäß einem Ausführungsbeispiel kann die Halbleitervorrichtung einen FeRAM umfassen und die Speicherzelle kann zumindest einen Teil einer Kondensatorstruktur oder einer Gatestruktur der Halbleitervorrichtung bilden. Bildet die Speicherzelle beispielsweise einen Teil der Kondensatorstruktur, so kann je nach Ausgangszustand einer Polarisation der Speicherzelle ein während eines Lesevorgangs der Halbleitervorrichtung variierender Strom fließen. Somit wird ein zuverlässiges Speichern und Langzeitstabilität der gespeicherten Informationen gewährleistet. Bildet die Speicherzelle zumindest einen Teil der Gatestruktur der Halbleitervorrichtung, so kann die Halbleitervorrichtung gleiche oder ähnliche Funktionalitäten, wie bereits oben bezüglich des FeFETs beschrieben, aufweisen.

Ein Ausführungsbeispiel betrifft eine integrierte Schaltung mit einer ferroelektrischen Halbleitervorrichtung. Somit kann eine integrierte Schaltung bereitgestellt werden, die ein zuverlässiges Speichern, gute Skalierbarkeit und Langzeitstabilität der gespeicherten Informationen gewährleistet.

Ein Ausführungsbeispiel schafft ein Verfahren zur Herstellung einer ferroelektrischen Halbleitervorrichtung. Das Verfahren kann ein Herstellen einer Halbleitervorrichtung und ein Ausbilden einer Speicherzelle mit einer ferroelektrischen Speicherschicht und einer ersten leitfähigen Schicht, die an der ferroelektrischen Speicherschicht angeordnet ist aufweisen. Die ferroelektrische Speicherschicht der Speicherzelle kann einen Mischkristall mit einem Gruppe-III-Nitrid und einem Nicht-Gruppe-III-Element aufweisen. Die Speicherzelle kann mit der Halbleitervorrichtung verbunden werden.

Gemäß einem Ausführungsbeispiel kann das Ausbilden der Speicherzelle ein Ausbilden der ferroelektrischen Speicherschicht mittels reaktiver Abscheidung auf der Halbleitervorrichtung und ein Ausbilden der ersten leitfähigen Schicht auf der ferroelektrischen Speicherschicht aufweisen.

### Figurenkurzbeschreibung

Ausführungsbeispiele gemäß der vorliegenden Erfindung werden nachfolgend Bezug nehmend auf die beiliegenden Figuren näher erläutert. Hinsichtlich der dargestellten schematischen Figuren wird darauf hingewiesen, dass die dargestellten Funktionsblöcke sowohl als Elemente oder Merkmale der erfindungsgemäßen Vorrichtung als auch als entsprechende Verfahrensschritte des erfindungsgemäßen Verfahrens zu verstehen sind, und auch entsprechende Verfahrensschritte des erfindungsgemäßen Verfahrens davon abgeleitet werden können. Es zeigen:
- Fig. 1: eine schematische Darstellung einer ferroelektrischen Halbleitervorrichtung gemäß einem Ausführungsbeispiel der vorliegenden Erfindung;
- Fig. 2a: eine schematische Darstellung einer Speicherzelle für eine ferroelektrische Halbleitervorrichtung gemäß einem Ausführungsbeispiel der vorliegenden Erfindung;
- Fig. 2b: eine schematische Darstellung einer Speicherzelle mit einer isolierenden Schicht für eine ferroelektrische Halbleitervorrichtung gemäß einem Ausführungsbeispiel der vorliegenden Erfindung;
- Fig. 2c: eine schematische Darstellung einer Speicherzelle mit einer zweiten leitfähigen Schicht für eine ferroelektrische Halbleitervorrichtung gemäß einem Ausführungsbeispiel der vorliegenden Erfindung;
- Fig. 2d: eine schematische Darstellung einer Speicherzelle mit einer zweiten leitfähigen Schicht und einer isolierenden Schicht für eine ferroelektrische Halbleitervorrichtung gemäß einem Ausführungsbeispiel der vorliegenden Erfindung;
- Fig. 2e: eine schematische Darstellung einer Speicherzelle mit einer ferroelektrischen Speicherschicht, die eine geringere Ausdehnung parallel zu einer Oberfläche einer ersten leitfähigen Schicht aufweist als eine isolierende Schicht und/oder eine zweite leitfähige Schicht, für eine ferroelektrische Halbleitervorrichtung gemäß einem Ausführungsbeispiel der vorliegenden Erfindung;
- Fig. 3: eine schematische Darstellung einer Transmission-Elektronen-Mikroskopie einer Speicherzelle für eine ferroelektrische Halbleitervorrichtung gemäß einem Ausführungsbeispiel der vorliegenden Erfindung;
- Fig. 4a: eine schematische Darstellung einer Transmission-Elektronen-Mikroskopie einer Speicherzelle mit einer zweiten leitfähigen Schicht für eine ferroelektrische Halbleitervorrichtung gemäß einem Ausführungsbeispiel der vorliegenden Erfindung;
- Fig. 4b: eine schematische Darstellung eines Elektronen-Beugungsbildes einer Gitterstruktur eines Mischkristalls einer Speicherzelle für eine ferroelektrische Halbleitervorrichtung gemäß einem Ausführungsbeispiel der vorliegenden Erfindung;
- Fig. 5: eine schematische Darstellung eines Mischkristalls einer Speicherzelle für eine ferroelektrische Halbleitervorrichtung gemäß einem Ausführungsbeispiel der vorliegenden Erfindung;
- Fig. 6: eine schematische Darstellung einer ferroelektrischen Halbleitervorrichtung, wobei eine Halbleitervorrichtung einen FeFET umfasst, gemäß einem Ausführungsbeispiel der vorliegenden Erfindung;
- Fig. 7a: eine schematische Darstellung einer ferroelektrischen Halbleitervorrichtung, wobei eine Halbleitervorrichtung einen FinFET umfasst, mit U-förmiger Speicherzelle gemäß einem Ausführungsbeispiel der vorliegenden Erfindung;
- Fig. 7b: eine schematische Darstellung einer ferroelektrischen Halbleitervorrichtung, wobei eine Halbleitervorrichtung einen FinFET umfasst, mit O-förmiger Speicherzelle gemäß einem Ausführungsbeispiel der vorliegenden Erfindung;
- Fig. 8: eine schematische Darstellung einer ferroelektrischen Halbleitervorrichtung, wobei eine Halbleitervorrichtung einen FeRAM umfasst, gemäß einem Ausführungsbeispiel der vorliegenden Erfindung;
- Fig. 9a: ein Diagramm von P-E Schleifen eines Mischkristalls einer Speicherzelle für eine ferroelektrische Halbleitervorrichtung gemäß einem Ausführungsbeispiel der vorliegenden Erfindung;
- Fig. 9b: eine schematische Darstellung eines Mischkristalls einer Speicherzelle für eine ferroelektrische Halbleitervorrichtung mit einer Metall-Polarisation gemäß einem Ausführungsbeispiel der vorliegenden Erfindung;
- Fig. 9c: eine schematische Darstellung eines Mischkristalls einer Speicherzelle für eine ferroelektrische Halbleitervorrichtung mit keiner Polarisation gemäß einem Ausführungsbeispiel der vorliegenden Erfindung;
- Fig. 9d: eine schematische Darstellung eines Mischkristalls einer Speicherzelle für eine ferroelektrische Halbleitervorrichtung mit einer N-Polarisation gemäß einem Ausführungsbeispiel der vorliegenden Erfindung;
- Fig. 9e: ein Diagramm von Ladungs-Dehnungskurven eines Mischkristalls einer Speicherzelle für eine ferroelektrische Halbleitervorrichtung gemäß einem Ausführungsbeispiel der vorliegenden Erfindung;
- Fig. 9f: ein Diagramm einer Dehnungsantwort auf ein elektrisches Feld von einem Mischkristall einer Speicherzelle für eine ferroelektrische Halbleitervorrichtung gemäß einem Ausführungsbeispiel der vorliegenden Erfindung;
- Fig. 10a: ein Diagramm eines mittleren Koerzitivfeldes E_{C} über einer mechanischen Verspannung T_{R} eines Mischkristalls einer Speicherzelle für eine ferroelektrische Halbleitervorrichtung gemäß einem Ausführungsbeispiel der vorliegenden Erfindung;
- Fig. 10b: ein Diagramm eines mittleren Koerzitivfeldes E_{C} über einem Nicht-Gruppe-III-Elementgehalt eines Mischkristalls einer Speicherzelle für eine ferroelektrische Halbleitervorrichtung gemäß einem Ausführungsbeispiel der vorliegenden Erfindung;
- Fig. 11: ein Diagramm von einer Hysteresebreite, einem Hysteresezentrum und einem transversalen piezoelektrischen Koeffizienten über einer Temperatur für einen Mischkristall einer Speicherzelle einer ferroelektrischen Halbleitervorrichtung gemäß einem Ausführungsbeispiel der vorliegenden Erfindung; und
- Fig. 12: ein Blockdiagramm eines Verfahrens zur Herstellung einer Speicherzelle gemäß einem Ausführungsbeispiel der vorliegenden Erfindung.

### Detaillierte Beschreibung der Ausführungsbeispiele gemäß den Figuren

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen oder ähnlichen Bezugszeichen versehen sind, so dass die in unterschiedlichen Ausführungsbeispielen dargestellte Beschreibung dieser Elemente untereinander austauschbar ist bzw. aufeinander angewendet werden kann.

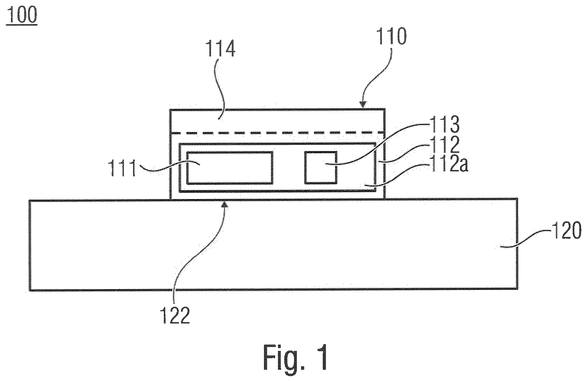

Fig. 1 zeigt eine schematische Darstellung einer ferroelektrischen Halbleitervorrichtung 100 mit einer Speicherzelle 110 und einer Halbleitervorrichtung 120, die mit der Speicherzelle 110 verbunden ist. Die Speicherzelle 110 kann eine ferroelektrische Speicherschicht 112 und eine erste leitfähige Schicht 114, die an der ferroelektrischen Speicherschicht 112 angeordnet ist, aufweisen. Die ferroelektrische Speicherschicht 112 der Speicherzelle 110 kann einen Mischkristall 112a mit einem Gruppe-III-Nitrid 111 und einem Nicht-Gruppe-III-Element 113 aufweisen. Somit kann die ferroelektrische Halbleitervorrichtung 100 ein erstes Gruppe-III-Nitrid basiertes Ferroelektrikum in der ferroelektrischen Speicherschicht 112 aufweisen.

Die komplette ferroelektrische Speicherschicht 112 kann beispielsweise den Mischkristall 112a aufweisen. Hierbei ist anzumerken, dass Fig. 1 nur eine schematische Skizze ist. Auch wenn in Fig. 1 das Gruppe-III-Nitrid 111 und das Nicht-Gruppe-III-Element 113 räumlich getrennt voneinander dargestellt sind, ist dies in Wirklichkeit nicht der Fall. In dem Mischkristall 112a ist z. B. eine chemische Verbindung des Gruppe-III-Nitrids mit dem Nicht-Gruppe-III-Element homogen verteilt. Somit können in dem Mischkristall 112a das Gruppe-III-Nitrid und das Nicht-Gruppe-III-Element eine Verbindung miteinander eingehen. Der Mischkristall 112a kann beispielsweise AIScN, GaScN, InScN, AINbMgN, GaNbMgN, InNbMgN, AlGaNbMgN, etc. aufweisen.

Gemäß Fig. 1 kann die Speicherzelle 110 so an der Halbleitervorrichtung 120 angeordnet sein, dass sie über eine Verbindungsoberfläche 122 miteinander verbunden sind.

Gemäß einem Ausführungsbeispiel kann die Speicherzelle 110 eine U-Form, eine O-Form, eine zylindrische Form oder eine Quaderform aufweisen. Je nach Halbleitervorrichtung 120 kann somit eine individuell angepasste Speicherzelle 110 mit der Halbleitervorrichtung 120 verbunden werden.

Gemäß einem Ausführungsbeispiel kann das Gruppe-III-Nitrid 111 des Mischkristalls 112a der ferroelektrischen Speicherschicht 112 AIN, GaN, InN oder eine Kombination dieser aufweisen. Eine Kombination kann beispielsweise AIGaN, AlInN oder GaInN sein.

Gemäß einem Ausführungsbeispiel kann das Nicht-Gruppe-III-Element 113 ein Übergangsmetall oder Mg aufweisen, Somit kann das Nicht-Gruppe-III-Element beispielsweise Sc, Y, Nb, Mg oder Ti sein.

Es ist anzumerken, dass der Mischkristall 112a eine Vielzahl von Gruppe-III-Nitriden 111 und eine Vielzahl an Nicht-Gruppe-III-Elementen 113 aufweisen kann. Dabei können die Gruppe-III-Nitride 111 mit den Nicht-Gruppe-III-Elementen 113 chemische Verbindungen eingehen, um so den Mischkristall 112a zu bilden.

Gemäß einem Ausführungsbeispiel können die Nicht-Gruppe-III-Elemente 113 20 bis 50 % der Plätze von Gruppe-III-Atomen der Gruppe-III-Nitride 111 innerhalb des Mischkristalls 112a besetzen. Die Gruppe-III-Atome können dabei beispielsweise Al, Ga oder In sein. In anderen Worten repräsentieren die 20 bis 50 % einen Anteil der Nicht-Gruppe-III-Elemente 113 bezogen auf die Gruppe-III-Atome der Gruppe-III-Nitride 111 in dem Mischkristall 112a. Der Anteil der Nicht-Gruppe-III-Elemente 113 kann so gewählt sein, dass die ferroelektrische Speicherschicht 112 ferroelektrische Eigenschaften aufweist. Dies basiert auf der Erkenntnis, dass der Mischkristall 112a basierend auf Gruppe-III-Nitriden 111 (GaN, AIN, InN) unter bestimmten Bedingungen ferroelektrisch sein kann. Ob Ferroelektrizität beobachtet werden kann, kann dabei von der Beimischung einzelner oder mehrerer zusätzlicher Metalle (ein Beispiel für ein Nicht-Gruppe-III-Element 113, wie z. B. Sc, Y, Nb, Ti, Mg, etc.) und von einer mechanischen Spannung innerhalb der ferroelektrischen Speicherschicht 112 abhängen.

Gemäß einem Ausführungsbeispiel kann die mechanische Verspannung der ferroelektrischen Speicherschicht 112 so gewählt sein, dass die ferroelektrische Speicherschicht 112 ferroelektrische Eigenschaften aufweist. Die mechanische Verspannung der ferroelektrischen Speicherschicht 112 kann innerhalb eines Intervalls von -500 MPa bis 2000 MPa, - 300 MPa bis 1000 MPa oder von -250 MPa bis 500 MPa liegen.

Ein Vorteil des beschriebenen Lösungsansatzes mit Gruppe-III-Nitriden 111 ist der Betrag der Polarisation der ferroelektrischen Speicherschicht 112. Dieser kann Wert von über 100 µC/cm² erreichen, was deutlich mehr als fast alle alternativen Ferroelektrika, wie z. B. PZT, BTO und Hafnium-Oxid basierte Verbindungen sein kann.

Gemäß einem Ausführungsbeispiel kann die Halbleitervorrichtung 120 ein FET, z.B. ein planarer MOSFET, ein FinFET oder ein HEMT etc. aufweisen. Die ferroelektrische Speicherzelle 110 kann ein Teil der Gate-Struktur des FETs sein, dieser kann damit einem FeFET entsprechen. Die hohe Polarisation der ferroelektrischen Speicherschicht 112 der Speicherzelle 110 kann ein besonders effizientes Öffnen und Schließen eines FET-Kanals gewährleisten.

Gemäß einem Ausführungsbeispiel kann die Halbleitervorrichtung 120 eine RAM aufweisen. Die Speicherzelle 110 kann einen Teil einer Kondensatorstruktur der Halbleitervorrichtung bilden. Die hohe Polarisation der ferroelektrischen Speicherschicht 112 der Speicherzelle 110 kann einen besonders großen Unterschied eines Auslesestroms einer FeRAM-Zelle gewährleisten.

Das Material (z. B. der Mischkristall 112a) der ferroelektrischen Speicherschicht 112 kann bereits auf ersten Nanometern, ausgehend von einem Substrat (das Substrat kann beispielsweise die erste leitfähige Schicht 114, eine zweite leitfähige Schicht, eine isolierende Schicht oder die Halbleitervorrichtung 120 umfassen), in einer ferroelektrischen Kristallstruktur (Wurtzit-Struktur) kristallisiert sein, was den Mischkristall 112a bilden kann, und kann eine korrekte Orientierung aufweisen. Somit ist eine gute Skalierbarkeit hin zu möglichst dünnen Schichten (z. B. der ferroelektrischen Speicherschicht 112) gewährleistet, was eine hohe Dichte an Speicherzellen 110 ermöglicht.

Gemäß einem Ausführungsbeispiel kann der Mischkristall 112a der ferroelektrischen Speicherschicht 112 ein hohes Koerzitivfeld kleiner als eine Durchbruchspannung des Mischkristalls 112a aufweisen. Das hohe und zudem durch eine Zusammensetzung (z. B. aus dem Gruppe-III-Nitrid 111 und dem Nicht-Gruppe-III-Element 113) und die mechanische Spannung einstellbare Koerzitivfeld kann sicherstellen, dass insbesondere bei einer sehr geringen Schichtdicke (wenigen Nanometern) der ferroelektrischen Speicherschicht 112 attraktive elektrische Schwellspannungen von wenigen Volt für ein Speichern von Informationen erreicht werden können.

Ein Vorteil der ferroelektrischen Speicherschicht 112 ist, dass der Mischkristall 112a bei geringen Abscheidetemperaturen (in der Regel 300°C bis 400°C , 310°C bis 390°C oder 320°C bis 380°C) abgeschieden werden kann, was ermöglicht, dass der Mischkristall 112a (z. B. das ferroelektrische Material) auch nach einem finalen Dotierungs-Diffusionsschritt abgeschieden werden kann und CMOS-Kompatibel eingesetzt werden kann.

Somit ist festzuhalten, dass die neuen Gruppe-III-Nitrid 111 basierten Speicherzellen 110 gegenüber dem Stand der Technik ein deutlich zuverlässigeres Speichern von Daten mit guter Skalierbarkeit ermöglichen. Dies kann eine direkte Folge der besonders stabilen und gleichzeitig großen elektrischen Polarisation in der beschriebenen Materialklasse (z. B. der Gruppe-III-Nitrid-basierten Mischkristalle) sein. Durch die gewonnene Zuverlässigkeit der ferroelektrischen Halbleitervorrichtung 100 bei hohen Temperaturen ließen sich nicht-flüchtige ferroelektrische Speicher (wie z. B. die ferroelektrische Halbleitervorrichtung 100) z. B. auch in unmittelbarer Nähe zu Verbrennungsmotoren oder Triebwerken einsetzen.

Gemäß einem Ausführungsbeispiel kann die ferroelektrische Speicherschicht 112 aufgrund ihrer speziellen Materialzusammensetzung aus Gruppe-III-Nitriden 111 und Nicht-Gruppe-III-Elementen 113, hohen Temperaturen standhalten. So kann die ferroelektrische Speicherschicht 112 beispielsweise Temperaturen von über 400°C, 500°C oder 600°C ausgesetzt sein, ohne eine wesentliche Minderung von Eigenschaften der ferroelektrischen Speicherschicht 112 einzubüßen.

In der nachfolgenden Tabelle 1 werden Eigenschaften der ferroelektrischen Speicherschicht 112 mit dem Mischkristall 112a mit alternativen ferroelektrischen Materialien, wie z. B. PZT und HfO₂ gegenübergestellt. Hierfür wird für den Mischkristall 112a ein konkretes Beispiel gewählt, bei dem es sich bei dem Gruppe-III-Nitrid 111 um AIN und bei dem Nicht-Gruppe-III-Element 113 um Sc handelt. Somit kann der Mischkristall 112a eine chemische Verbindung zwischen dem Gruppe-III-Nitrid 111 und dem Nicht-Gruppe-III-Element 113 aufweisen, die als Al₁₋ₓ ScₓN dargestellt werden kann. Der Index x kann hierbei eine Zahl zwischen 0 und 1 aufweisen und den Anteil an dem Nicht-Gruppe-III-Element 113 (in diesem Fall z. B. Sc) an dem Gruppe-III-Nitrid 111 (in diesem Fall z. B. AIN) darstellen. Die Werte für PZT und HfO₂ wurden der Literatur [35] entnommen.

**Tabelle 1**

| **Eigenschaft** | **PZT** | **Fe-HfO₂** | **Fe-Al₁₋ₓScₓN** |
|---|---|---|---|
| Schichtdicke | > 70 nm | 5-30 nm | <10 nm bis >1000 nm |
| Annealing/Abscheidetemperatur | > 600°C | 450°C-1000°C | <400°C |
| Remanenzpolarisation | 20-40 µC/cm² | 1-40 µC/cm² | 60-110µC/cm² |
| Koerzitivfeldstärke | ~ 50 kV/cm | 1-2 MV/cm | 1,8-4 MV/cm |
| Durchbruchfeldstärke | 0,5-2 MV/cm | 4-8 MV/cm | > 4 MV/cm |
| CMOS-Kompatibilität | Pb und O Diffusion | gegeben | gegeben |
| BEOL-Kompatibilität | Schäden durch H₂ | gegeben | gegeben |
| Maximale Betriebstemperatur | 100-200°C | 300-400°C | > 600°C |

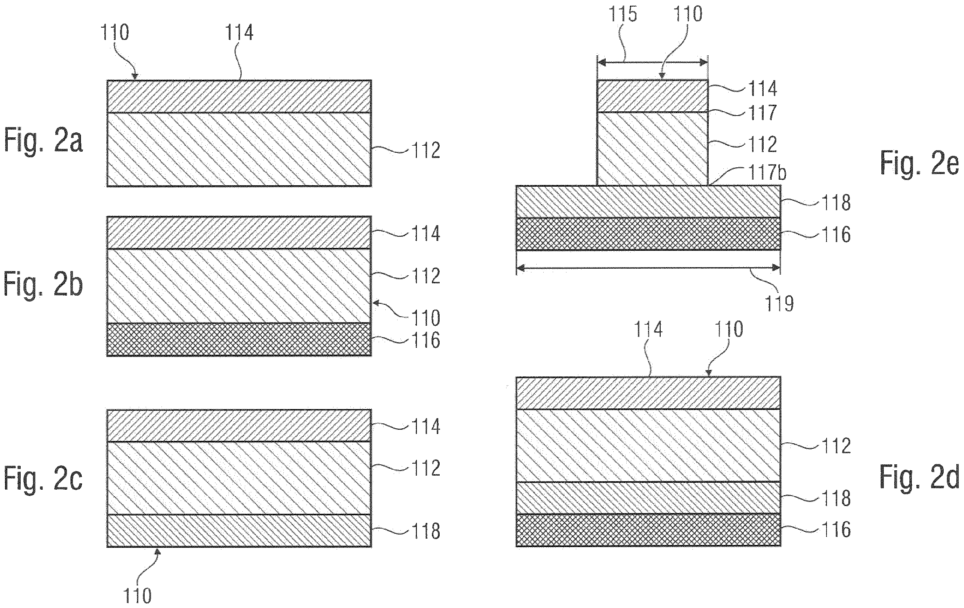

Fig. 2a bis Fig. 2d zeigen unterschiedliche Ausführungsbeispiele einer Speicherzelle 110 mit einer ersten leitfähigen Schicht 114 und einer ferroelektrischen Speicherschicht 112. Die erste leitfähige Schicht 114 kann an der ferroelektrischen Speicherschicht 112 angeordnet sein. Die ferroelektrische Speicherschicht 112 der Speicherzelle 110 kann einen Mischkristall mit einem Gruppe-III-Nitrid und einem Nicht-Gruppe-III-Element aufweisen.

Gemäß einem Ausführungsbeispiel kann die ferroelektrische Speicherschicht 112 aus Gruppe-III-Elemente, wie z. B. Al, Ga oder In oder Kombinationen dieser, Stickstoff N sowie ein Nicht-Gruppe-III-Element, wie z. B. ein Metall Sc, Mg, Nb, Y, Ti oder Kombinationen dieser, bestehen. Dabei können das Gruppe-III-Element und der Stickstoff das Gruppe-III-Nitrid bilden. Der Anteil des zusätzlichen Nicht-Gruppe-III-Elements (z. B. Metall oder Metalle) sowie eine mechanische Verspannung können während eines Herstellungsprozesses so eingestellt werden, dass das Material (z. B. die ferroelektrische Speicherschicht 112) ferroelektrisch wird. Die mechanische Verspannung kann auch im Nachhinein, z. B. durch ein Aufbringen zusätzlicher Schichten, eingestellt werden.

Gemäß einem Ausführungsbeispiel kann die erste leitfähige Schicht 114 z. B. ein Metall wie Pt, Cr, Au, Ti, Al, Cu, Mo oder eine Legierung oder ein Mehrlagensystem aufweisen. Die erste leitfähige Schicht 114 kann aber auch aus einem Halbleiter aufgebaut sein, der entsprechend dotiert sein kann (z. B. Si, Ga, GaN, SiC) oder auch z. B. TiN bzw. TiAIN aufweisen kann.

Gemäß einem Ausführungsbeispiel kann die Speicherzelle 110, siehe z. B. Fig. 2b, eine isolierende Schicht 116, die ferroelektrische Speicherschicht 112 und die erste leitfähige Schicht 114 aufweisen, die in dieser Reihenfolge angeordnet sind. Die isolierende Schicht 116 kann z. B. aus SiO₂, HfO₂, Al₂O₃, AIN, GaN oder darauf basierenden Mischkristallen bestehen. Die isolierende Schicht 116 kann z. B. ein standardmäßig in der Halbleiterindustrie eingesetztes Gate-Dielektrikum sein.

Gemäß einem Ausführungsbeispiel kann die Speicherzelle 110, wie z. B. in Fig. 2c, eine zweite leitfähige Schicht 118, die ferroelektrische Speicherschicht 112, und die erste leitfähige Schicht 114 aufweisen, die in dieser Reihenfolge angeordnet sind. Die erste leitfähige Schicht 114 sowie die zweite leitfähige Schicht 118 können beispielsweise das gleiche Material oder zwei unterschiedliche Materialien aufweisen. Die erste leitfähige Schicht 114 sowie die zweite leitfähige Schicht 118 können die gleichen Merkmale und Funktionalitäten wie die erste leitfähige Schicht 114 aus Fig. 2a aufweisen.

Gemäß einem Ausführungsbeispiel kann die Speicherzelle 110, wie z. B. in Fig. 2d, eine isolierende Schicht 116, eine zweite leitfähige Schicht 118, die ferroelektrische Speicherschicht 112 und die erste leitfähige Schicht 110 aufweisen, die in dieser Reihenfolge angeordnet sind. Hierbei kann die zweite leitfähige Schicht 118 dieselben Merkmale und Funktionalitäten wie die zweite leitfähige Schicht 118 aus Fig. 2c aufweisen und die isolierende Schicht 116 dieselben Merkmale und Funktionalitäten wie die isolierende Schicht 116 aus Fig. 2b.

Gemäß einem Ausführungsbeispiel kann die Speicherzelle 110, wie z. B. in Fig. 2e dargestellt, denselben Schichtaufbau aufweisen wie in Fig. 2d dargestellt, nur dass die ferroelektrische Speicherschicht 112 eine geringere Ausdehnung (z. B. eine erste Ausdehnung 115 und eine zweite Ausdehnung senkrecht zur Ausdehnung 115, in die Blattebene hinein) parallel zu einer Oberfläche 117 der ersten leitfähigen Schicht 114 aufweisen kann als die isolierende Schicht 116 und die zweite leitfähige Schicht 118. Die isolierende Schicht 116 und die zweite leitfähige Schicht 118 weist beispielsweise eine erste Ausdehnung 119 größer als die erste Ausdehnung 115 der ferroelektrischen Speicherschicht 112 auf. Hierbei ist anzumerken, dass auch eine zweite Ausdehnung der isolierenden Schicht 116 senkrecht zur ersten Ausdehnung 119, in die Blattebene hinein, größer sein kann als die zweite Ausdehnung der ferroelektrischen Speicherschicht 112.

Gemäß einem Ausführungsbeispiel kann ebenso die ferroelektrische Speicherschicht 112 der Speicherzelle 110 mit einem Schichtaufbau gemäß Fig. 2b oder Fig. 2c eine geringere Ausdehnung als die isolierende Schicht 116 (siehe Fig. 2b) oder die zweite leitfähige Schicht 118 (siehe Fig. 2c) parallel zu einer Oberfläche der ersten leitfähigen Schicht 114 aufweisen.

Die Oberfläche 117 (siehe Fig. 2e) verbindet beispielsweise die erste leitfähige Schicht 114 mit der ferroelektrischen Speicherschicht 112. In anderen Worten kann die erste leitfähige Schicht 114 die Oberfläche 117 aufweisen, die an der ferroelektrischen Speicherschicht 112 angeordnet sein kann. Gemäß dem Ausführungsbeispiel, dargestellt in Fig. 2e, kann die Isolationsschicht 116 und optional die zweite leitfähige Schicht 118 über die ferroelektrische Speicherschicht 112 hinausstehen.

Gemäß einem Ausführungsbeispiel kann eine Oberfläche 117b der ferroelektrischen Speicherschicht 112, parallel zu der Oberfläche 117 der ersten leitfähigen Schicht 114, so angepasst sein, dass beispielsweise durch an der ferroelektrischen Speicherschicht Schicht 112 anliegende Ladung die isolierende Schicht 116 nicht mit einer elektrischen Spannung über deren Durchbruchspannung belastet wird. Dies kann besonders der Fall sein, wenn die ferroelektrische Speicherschicht 112 beispielsweise eine große Polarisation aufweist, die mit vielen Ladungen an Grenzflächen einhergehen kann, welche zu übergroßen Spannungen an der Isolationsschicht führen können.

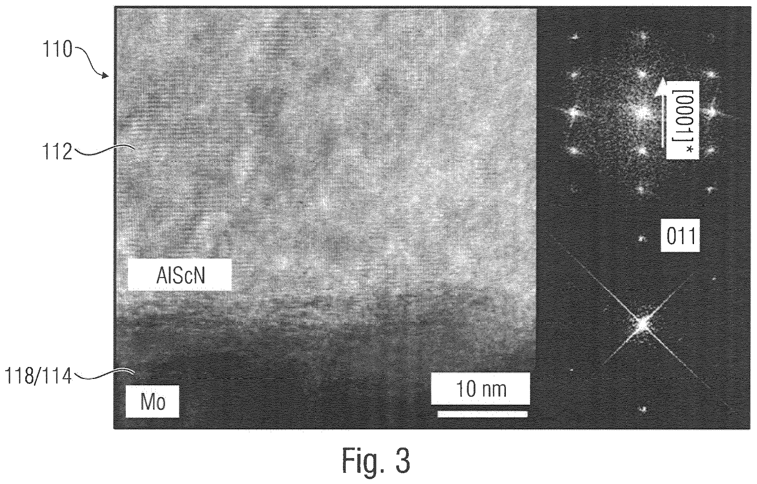

Fig. 3 zeigt eine Transmission-Elektronen-Mikroskopieaufnahme einer Speicherzelle 110. Gemäß einem Ausführungsbeispiel kann die Speicherzelle 110 eine leitfähige Schicht 118/114 und eine ferroelektrische Speicherschicht 112 aufweisen. Gemäß einem expliziten Beispiel kann die ferroelektrische Speicherschicht 112 den Mischkristall Al_{0.73}Sc_{0.27}N mit einem Gruppe-III-Nitrid AIN und einem Nicht-Gruppe-III-Element Sc aufweisen. Die leitfähige Schicht 118/114 kann gemäß einem expliziten Beispiel eine Molybdän-Elektrode aufweisen.

Eine Analyse der Struktur der Speicherzelle 110 kann ein gerichtetes kristallines Wachstum bereits auf den ersten 10 nm ergeben. Eine Achse der elektrischen Polarisation der ferroelektrischen Speicherschicht 112 kann senkrecht zum Substrat (z. B. die leitfähige Schicht 118/114) zeigen. In anderen Worten ist das Material (z. B. Al_{0.73}Sc_{0.27}N) der ferroelektrischen Speicherschicht 112 beispielsweise bereits auf den ersten Nanometern, ausgehend von dem Substrat, in einer ferroelektrischen Kristallstruktur (Wurtzit-Struktur) kristallisiert und weist eine korrekte Orientierung auf.

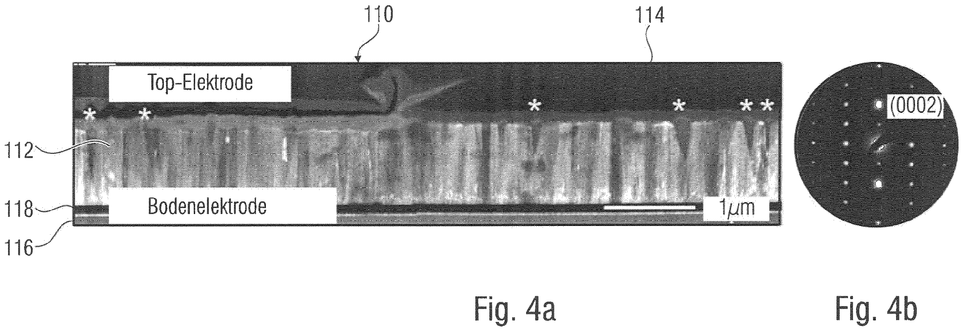

Fig. 4a zeigt ein schematisches TEM-Dunkelfeldbild (TEM=Transmission-Elektronen-Mikroskopie), das eine Intensität einer (0002)-Reflexion einer Speicherzelle 110, für eine ferroelektrische Halbleitervorrichtung, skizziert, die in dem PED-Bild (Präzession Elektronenbeugung), siehe Fig. 4b, angegeben sein kann. Falsch ausgerichtete Kristalle, die nicht die Wurtzit(0002)-Textur der Matrix zeigen, können mit einem dunkleren Kontrast in der helleren Kristallmatrix angezeigt sein und teilweise mit (*) angegeben sein.

Fig. 4a und Fig. 4b können ein explizites Beispiel der Speicherzelle 110 darstellen. So kann eine ferroelektrische Speicherschicht 112 beispielsweise Al_{0,57}Sc_{0,43}N aufweisen. Um die strukturelle Integrität des Al₁₋ₓScₓN-Films (x kann eine Zahl zwischen 0 und 1 darstellen) auf eine Polarisierungsinversion hin zu untersuchen, kann eine Mikrostruktur des Al_{0,57}Sc_{0,43}N-Films (der ferroelektrischen Speicherschicht 112) durch Transmissionselektronenmikroskopie (TEM) untersucht werden. Die TEM-Probe (Speicherzelle 110) wurde dahin gehend vorbereitet, dass dieselbe zwei Regionen enthält: eine (z. B. die ferroelektrische Speicherschicht 112), die zwischen Pt-Elektroden (z. B. zwischen einer ersten leitfähigen Schicht 114 und einer zweiten leitfähigen Schicht 118) angeordnet sein kann und einer ferroelektrischen Polarisierungsinversion unterliegen kann, und eine unveränderte Region 116, um einen strukturellen Vergleich zu ermöglichen. Eine Veranschaulichung von aneinander gehefteten TEM-Dunkelfeldbildern, die die Intensität der Wurtzit-Al_{0,57}Sc_{0,43}N (0002)-Reflexion skizzieren, ist in Fig. 4a gegeben, mit einem Präzessions-Elektronenbeugungs-Bild (precession electron diffraction, PED) der Wurtzit-Struktur in Fig. 4b. Es wurde kein wesentlicher Unterschied bezüglich des Kontrasts zwischen Kristallsäulen, z. B. der ferroelektrischen Speicherschicht 112, unterhalb der Pt-Top-Elektrode (z. B. die erste leitfähige Schicht 114), die für eine Polarisierungsinversion verwendet wird, und Kristallsäulen (z. B. der Region 116) beobachtet, die einem schaltenden elektrischen Feld nicht unterliegen, wobei das elektrische Feld durch die erste leitfähige Schicht 114 und die zweite leitfähige Schicht 118 hervorgerufen werden kann.

Aufgrund eines hohen Sc-Gehalts (gemäß dem Beispiel 43%) der spezifischen Probe (Speicherzelle 110) wurde eine Anzahl von falsch ausgerichteten Wurtzit-Körnern identifiziert, von denen einige in Fig. 4a durch Sternchen gekennzeichnet sind. Darüber hinaus wurden gelegentlich strukturelle Variationen in Form von potenziellen kubischen Körnern und eine nicht identifizierte Phase beobachtet.

Es ist jedoch zu betonen, dass die Mehrheit des Films (der ferroelektrischen Speicherschicht 112) bei ED-Experimenten als (0002)-texturiertes Al₁₋ₓScₓN identifiziert wurde, sowohl in der ursprünglichen als auch in der Region mit Polarisierungsinversion, und diese strukturellen Variationen wurden lediglich zufällig beobachtet und weisen eher geringe Volumenfraktionen auf. Das ferroelektrische Verhalten von Al₁₋ₓScₓN kann daher tatsächlich mit der Wurtzit-Struktur in Zusammenhang gebracht werden.

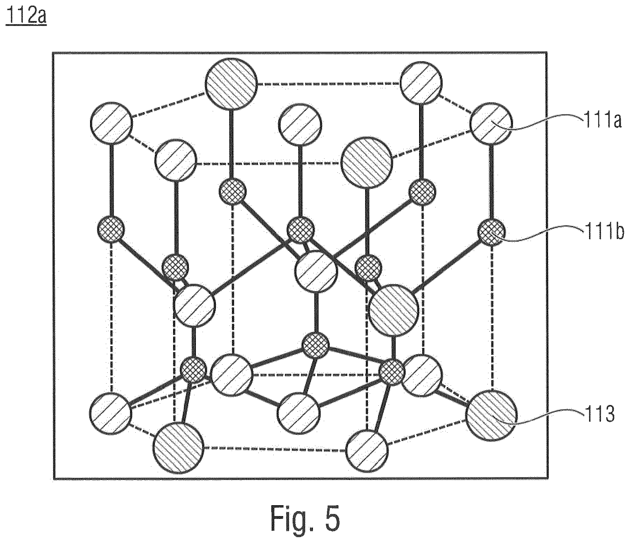

Fig. 5 zeigt eine schematische Darstellung eines Mischkristalls 112a einer Speicherzelle für eine ferroelektrische Halbleitervorrichtung gemäß einem Ausführungsbeispiel der vorliegenden Erfindung. Der Mischkristall 112a kann ein Gruppe-III-Nitrid, bestehend beispielsweise aus einem Gruppe-III-Atom 111a und Stickstoff N 111b, und ein Nicht-Gruppe-III-Element 113 aufweisen. Der Mischkristall gemäß Fig. 5 weist beispielsweise nicht stöchiometrisch betrachtet 12 Gruppe-III-Atome 111a, 10 Stickstoff N 111b und 5 Nicht-Gruppe-III-Elemente 113 auf. Stöchiometrisch betrachtet kann eine Anzahl der Stickstoffatome N 111b und der anderen Elemente (z. B. Gruppe-III-Atome 111a und Nicht-Gruppe-III-Elemente 113) gleich sein (Atome an den Ecken der Zelle zählen beispielsweise nicht voll). Der in Fig. 5 dargestellte Mischkristall 112a kann periodisch fortgesetzt werden.

Gemäß einem Ausführungsbeispiel können die Nicht-Gruppe-III-Elemente 113 20 bis 50 % der Plätze von Gruppe-III-Atomen 111a der Gruppe-III-Nitride innerhalb des Mischkristalls 112a besetzen. So besetzen beispielsweise in Fig. 5 die Nicht-Gruppe-III-Elemente 113 29 % der Plätze von Gruppe-III-Atomen 111a. Durch die spezielle Zusammensetzung des Mischkristalls 112a kann der Mischkristall 112a ferroelektrische Eigenschaften aufweisen.

Gemäß einem Ausführungsbeispiel kann der Mischkristall 112a aus Fig. 5 einen Ausschnitt aus einer ferroelektrischen Speicherschicht einer Speicherzelle für eine ferroelektrische Halbleitervorrichtung darstellen und in alle drei Raumrichtungen mit der Kristallstruktur fortgesetzt werden.

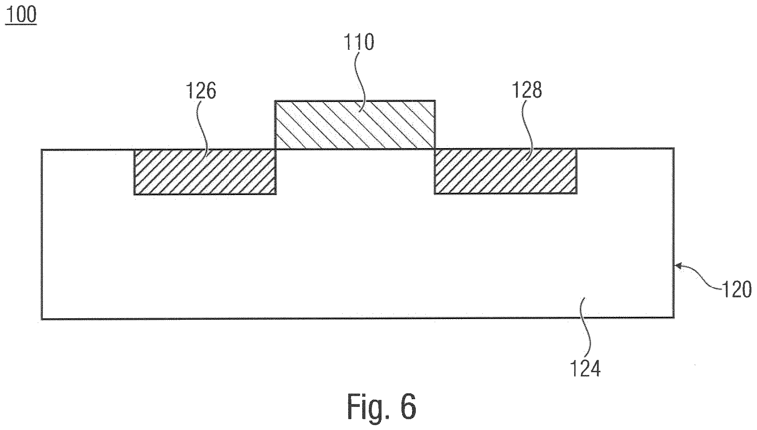

Fig. 6 zeigt eine schematische Darstellung einer ferroelektrischen Halbleitervorrichtung 100 gemäß einem Ausführungsbeispiel der vorliegenden Erfindung. Die ferroelektrische Halbleitervorrichtung 100 kann eine Speicherzelle 110 mit einer ferroelektrischen Speicherschicht und einer ersten leitfähigen Schicht, die an der ferroelektrischen Speicherschicht angeordnet ist, aufweisen. Des Weiteren kann die ferroelektrische Halbleitervorrichtung 100 eine Halbleitervorrichtung 120, die mit der Speicherzelle 110 verbunden sein kann, aufweisen. Gemäß Fig. 6 kann die Halbleitervorrichtung 120 mit der Speicherzelle 110 dahin gehend verbunden sein, dass die Speicherzelle 110 an der Halbleitervorrichtung 120 angeordnet ist. Die Speicherzelle 110 kann beispielsweise gemäß der Speicherzelle 110 dargestellt in den Fig. 2a bis 2e ausgestaltet sein. Dementsprechend kann die Speicherzelle 110 die gleichen Merkmale und Funktionalitäten wie die Speicherzelle 110 in Fig. 1 oder Fig. 2a bis Fig. 2d aufweisen.

Gemäß einem Ausführungsbeispiel kann die Halbleitervorrichtung 120 einen FET umfassen. Hierbei kann die Speicherzelle 110 beispielsweise zumindest einen Teil einer Gatestruktur der Halbleitervorrichtung 120 bilden. Somit kann die Speicherzelle 110 auch als Gate-Stack bezeichnet werden.

Gemäß einem Ausführungsbeispiel kann die Halbleitervorrichtung 120 ein Substrat 124, einen ersten Anschluss 126 und einen zweiten Anschluss 128 aufweisen, wobei der erste Anschluss 126 und der zweite Anschluss 128 eine Quelle/Senke (z. B. Source/Drain) bilden können. Das Substrat 124 kann z. B. Silizium, Siliziumcarbid (SiC), Germanium oder Gruppe-III-Nitride (wie z.B. AIN, GaN, InN) aufweisen und dotiert sein. Der FeFET (z. B. die Halbleitervorrichtung 120) kann auch als ferroelektrische 1T Speicherzelle oder als ferroelektrischer Feldeffekttransistor bezeichnet werden.

Gemäß einem Ausführungsbeispiel kann bei einem FeFET wie dargestellt in Fig. 6 ein Ferroelektrikum (z. B. die ferroelektrische Speicherschicht der Speicherzelle 110) direkt oberhalb eines Gates der Halbleitervorrichtung 120 angeordnet sein, oder lediglich durch ein dünnes Dielektrikum (z. B. eine isolierende Schicht) und/oder zusätzliche dünne Schichten (z. B. eine zweite leitfähige Schicht) von dem Gate der Halbleitervorrichtung 120 getrennt angeordnet sein. Eine schaltbare elektrische Polarisation von ferroelektrischem Material (z. B. der ferroelektrischen Speicherschicht der Speicherzelle 110) kann je nach Ausrichtung einen Source-Drain-Kanal der Halbleitervorrichtung 120 (z. B. ein Transistor (1T)) sehr schnell schließen bzw. öffnen. Somit können in der ferroelektrischen Halbleitervorrichtung 100 Vorteile von nicht-flüchtigen und flüchtigen Speichertechnologien vereint sein.

In anderen Worten kann die Speicherzelle 110 ausgelegt sein, um die Halbleitervorrichtung 120 basierend auf einer in der Speicherzelle 110 gespeicherten Information zu steuern. Bei der gespeicherten Information handelt es sich z. B. um eine Polarisationsausrichtung der Speicherzelle. Somit ist die Speicherzelle 110, gemäß einem Ausführungsbeispiel, ausgelegt, um die Halbleitervorrichtung 120 basierend auf der in der Speicherzelle 110 gespeicherten Information entweder in einen An-Zustand oder in einen Aus-Zustand zu versetzten. Dies bedeutet z. B. dass ein elektrischer Kanal (i.e. der Source-Drain-Kanal) zwischen dem ersten Anschluss 126 (e.g. Source) und dem zweiten Anschluss 128 (e.g. Drain) geöffnet oder geschlossen wird. In anderen Worten kann die Halbleitervorrichtung 120 in dem An-Zustand eine Leitfähigkeit größer oder gleich einer oberen Schwelle aufweisen und in dem Aus-Zustand eine Leitfähigkeit kleiner oder gleich einer unteren Schwelle aufweisen. Die gespeicherte Information in der Speicherzelle 110 bewirkt einen stärker leitenden (e.g. on-state, An-Zustand) oder einen schwächer leitenden oder nicht leidenden (e.g. off-state, Aus-Zustand) Zustand der Halbleitervorrichtung 120.

Somit werden, gemäß einem Ausführungsbeispiel, in der Speicherzelle 110 nicht nur Informationen für einige Anwendungen gespeichert, sondern z. B. ein Zustand eines FeFETs (e.g. die Halbleitervorrichtung 120) durch die ferroelektrische Schicht (der Speicherzelle 110) dauerhaft in einen on oder off Zustand versetzt (also z. B. dauerhaft, bis das ferroelektrische Material, der Speicherschicht 110, wieder geschaltet wird). Somit ist das Speichern einer Information nicht immer das letztendliche Ziel der Anwendung. Das ferroelektrische Material speichert in diesem Fall also z. B. den gewünschten Zustand des Transistors (e.g. die Halbleitervorrichtung 120). Gleichzeitig bewirkt z. B. die Polarisation der ferroelektrischen Schicht genau diesen Zustand.

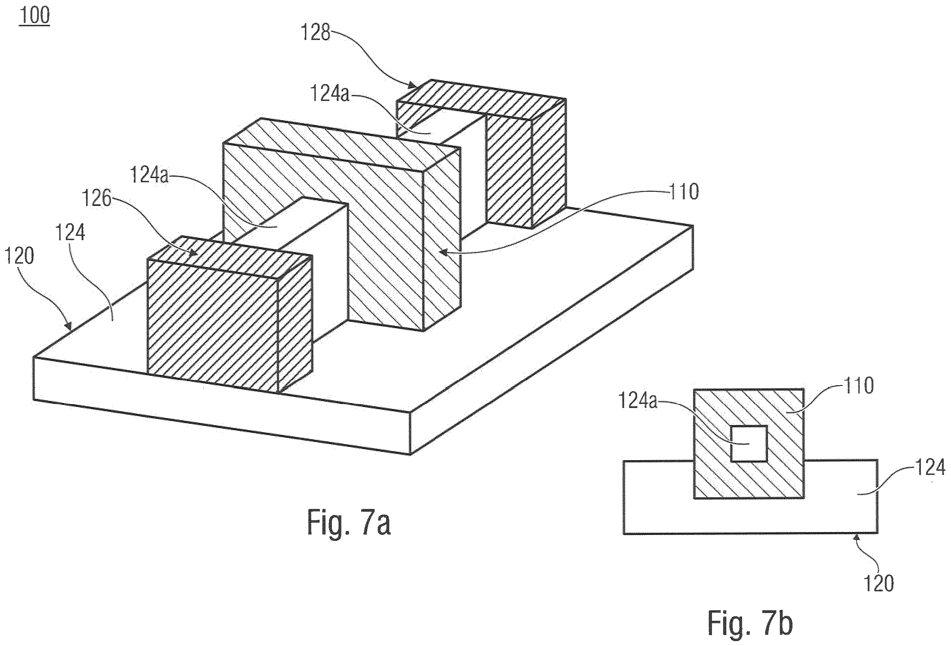

Dieses vorteilhafte Merkmal der schaltbaren Halbleitervorrichtung 120 mittels der Speicherzelle 110 ist nicht nur für den in Fig. 6 dargestellten FeFET geeignet. Alternativ kann ein planarer MOSFET, ein FinFET (wie z. B. dargestellt in Fig. 7a oder Fig. 7b) oder ein HEMT dieses Merkmal aufweisen.

Der FeFET kann Funktionen und Merkmale gemäß [31] aufweisen.

Fig. 7a zeigt eine schematische Darstellung einer ferroelektrischen Halbleitervorrichtung 100 mit einer Speicherzelle 110 und einer Halbleitervorrichtung 120, die mit der Speicherzelle 110 verbunden ist. Gemäß einem Ausführungsbeispiel kann es sich bei der Halbleitervorrichtung 120 um einen FinFET handeln. Gemäß einem Ausführungsbeispiel kann die Halbleitervorrichtung 120 ein Substrat 124 mit einer Finne 124a aufweisen. Zusätzlich kann die Halbleitervorrichtung 120 einen ersten Anschluss 126 und einen zweiten Anschluss 128, die als Quelle/Senke (z. B. Source/Drain) dienen können, aufweisen. In anderen Worten kann der FinFET eine ferroelektrische 1T Speicherzelle (FeFET) mit dreidimensionaler Gatestruktur (z. B. Finne 124a und Speicherzelle 110) darstellen. Somit kann die Speicherzelle 110 beispielsweise mit der Halbleitervorrichtung 120 dahin gehend verbunden sein, dass die Speicherzelle zumindest einen Teil einer Gatestruktur der Halbleitervorrichtung 120 bildet.

Gemäß einem Ausführungsbeispiel kann die Speicherzelle 110 gemäß Fig. 7a U-förmig ausgebildet sein. Hierfür können beispielsweise nacheinander die einzelnen Schichten der Speicherzelle 110, wie z. B. dargestellt in den Fig. 2a bis 2e, an zumindest einem Teil der Außenwände der Finne 124a der Halbleitervorrichtung 120 angeordnet/abgeschieden werden. Somit kann eine Schichtstruktur gemäß den Fig. 2a bis 2e senkrecht zu den Oberflächen der Finne 124a erreicht werden. In anderen Worten kann eine Schichtabfolge des Gates (z. B. die Speicherzelle 110) in einem Querschnitt horizontal zur Finne 124a den beschriebenen Schichtabfolgen aus Fig. 2a bis 2e entsprechen. Analog ließen sich auch andere dreidimensionale Gate/Kanalgeometrien realisieren, z. B. in Kanälen.

So kann beispielsweise gemäß Fig. 7b die Speicherzelle 110 eine O-Form aufweisen, durch die die Finne 124a geführt sein kann. Gemäß einem Ausführungsbeispiel kann das Substrat 124 der Halbleitervorrichtung 120 eine Vertiefung aufweisen, in der die Speicherzelle 110 angeordnet sein kann.

Gemäß einem Ausführungsbeispiel kann die ferroelektrische Halbleitervorrichtung 100 aus Fig. 7a über den ersten Anschluss 126 oder den zweiten Anschluss 128 mit einem zusätzlichen ferroelektrischen Kondensator, der beispielsweise die Speicherzelle 110 aus Fig. 2c sein kann, verbunden sein (FeRAM, 1T-1C). In diesem Fall kann die Speicherzelle 110 mit einem Gate-Stack eines konventionellen FETs ersetzt werden. In diesem Fall bildet beispielsweise der ferroelektrische Kondensator die Speicherzelle 110.

Gemäß einem Ausführungsbeispiel kann der FinFET Merkmale und Funktionalitäten gemäß [36] aufweisen.

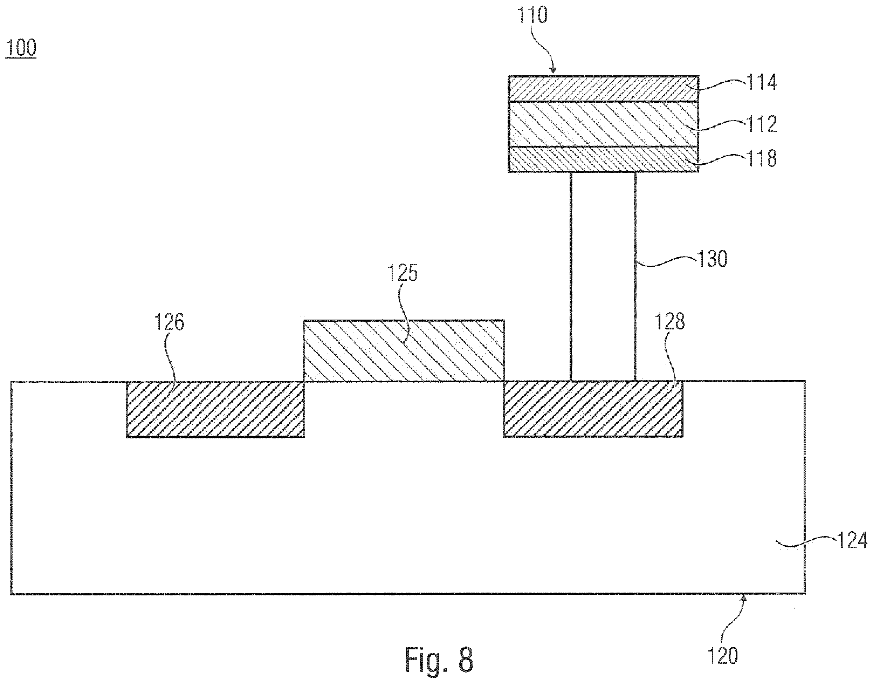

Fig. 8 zeigt eine schematische Darstellung einer ferroelektrischen Halbleitervorrichtung 100 mit einer Speicherzelle 110 und einer Halbleitervorrichtung 120, die mit der Speicherzelle 110 verbunden ist. Die Verbindung kann beispielsweise über Leitungen 130 erfolgen. Die Speicherzelle 110 kann beispielsweise gemäß Fig. 2c aufgebaut sein und somit eine erste leitfähige Schicht 114, eine ferroelektrische Speicherschicht 112 und eine zweite leitfähige Schicht 118 aufweisen.

In anderen Worten kann die Halbleitervorrichtung 120 beispielsweise einen FeRAM umfassen, wobei die Speicherzelle 110 zumindest einen Teil einer Kondensatorstruktur der Halbleitervorrichtung 120 bilden kann. Die Halbleitervorrichtung 120 kann ein Substrat 124, einen ersten Anschluss 126, einen zweiten Anschluss 128 und ein Gate 125 aufweisen. In anderen Worten kann die ferroelektrische Halbleitervorrichtung 100 eine ferroelektrische RAM-Zelle (1T-1C) darstellen.

Der aus leitenden Schichten 114, 118 und der ferroelektrischen Speicherschicht 112 gebildete Kondensator (Speicherzelle 110) kann über einen Leiter 130 mit dem zweiten Anschluss 128 (Source oder Drain-Kontakt) des Transistors (der Halbleitervorrichtung 120) verbunden sein. Der erste Anschluss 126 und der zweite Anschluss 128 können eine Quelle/Senke (Source/Drain) bilden. Das Gate 125 kann in diesem Fall den Gate-Stack eines konventionellen FETs (wie z.B. einem planaren MOSFET; einem FinFET, einem HEMT etc.) entsprechen (das heißt z. B. lediglich aus Gate-Dielektrikum und darüber liegendem Gate-Kontakt bestehen). Es ist aber auch möglich, dass das Gate 150 als Speicherzelle realisiert ist und einen Schichtaufbau gemäß einem der Fig. 2a bis 2e aufweist.

Gemäß einem Ausführungsbeispiel kann die Halbleitervorrichtung 100 analog zu einer DRAM-Zelle aufgebaut sein, das heißt z. B. aus einem Transistor und einem Kondensator (1T-1C) bestehen. Ein Dielektrikum des Kondensators (Speicherzelle 110) kann dabei durch ein ferroelektrisches Material (ferroelektrische Speicherschicht 112) ersetzt werden, welches über eine nicht-lineare (hysteretische) Strom/Spannungskennlinie verfügt. Je nach Ausgangszustand einer Polarisation (normalerweise senkrecht zum Substrat/vom Substrat weg (das Substrat kann beispielsweise die erste leitfähige Schicht 114 oder die zweite leitfähige Schicht 118 sein)) der ferroelektrischen Speicherschicht 112 kann während eines Lesevorgangs (der ferroelektrischen Halbleitervorrichtung 100) ein fließender Strom variieren. Somit kann die ferroelektrische Halbleitervorrichtung 100 Vorteile von nicht-flüchtigen und flüchtigen Speichertechnologien vereinen.

Gemäß einem Ausführungsbeispiel kann eine integrierte Schaltung eine ferroelektrische Halbleitervorrichtung 100, wie z. B. in den Fig. 1, 6, 7 oder 8 dargestellt, aufweisen.

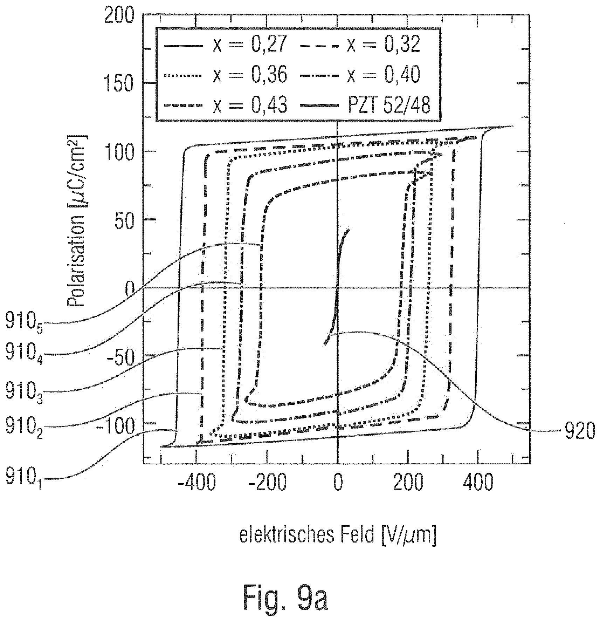

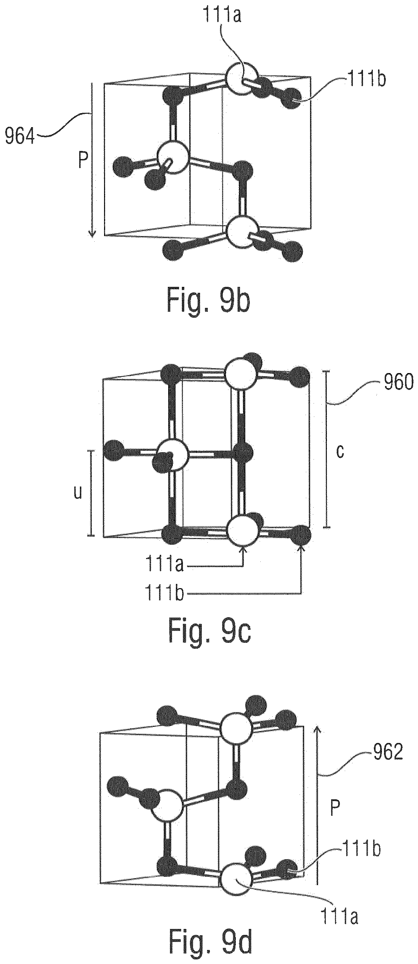

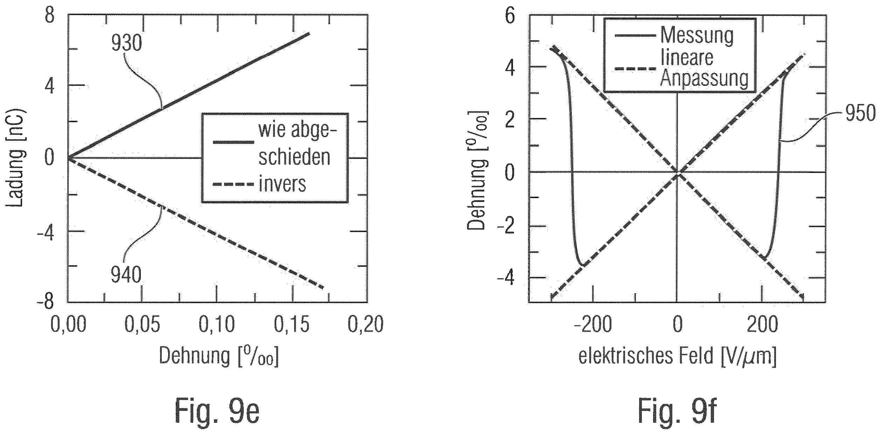

Fig. 9a zeigt ein Diagramm von P-E-Schleifen 910₁-910₅ einer ferroelektrischen Speicherschicht einer Speicherzelle für eine ferroelektrische Halbleitervorrichtung. Die ferroelektrische Speicherschicht umfasst beispielsweise ferroelektrisches Al₁₋ₓScₓN mit einem Sc-Gehalt von x = 0,27; 0,32; 0,36; 0,40 und 0,43. Als Vergleich wird eine P-E-Schleife 920 von PZT 52/48 in Fig. 9a dargestellt. Fig. 9b, Fig. 9b und Fig. 9c zeigen Strukturen, die den jeweiligen Polarisierungszuständen zugeordnet sind. Fig. 9d zeigt ein Diagramm, das einen direkten piezoelektrischen Effekt der ferroelektrischen Speicherschicht darstellen kann. So können in Fig. 9e Ladungs-Dehnungskurven der ferroelektrischen Speicherschicht wie abgeschieden 930 und nach ferroelektrischer Polarisierungsinversion 940 dargestellt werden. Gemäß einem Ausführungsbeispiel kann die ferroelektrische Speicherschicht Al_{0,64}Sc_{0,36}N aufweisen. Fig. 9f kann einen reziproken piezoelektrischen Effekt der ferroelektrischen Speicherschicht darstellen. Es kann sich hierbei beispielsweise um eine Längsdehnungsantwort 950 von Al_{0,64}Sc_{0,36}N handeln.

An dieser Stelle wird über experimentelle Beweise für ein erstes Material, umfassend ein Gruppe-III-Nitrid und ein nicht-Gruppe-III-Element, was als neue Gruppe von CMOSkompatiblen Ferroelektrika mit beachtlichen Eigenschaften zu erwarten ist, berichtet. Ein Mischkristall einer ferroelektrischen Speicherschicht einer Speicherzelle für eine ferroelektrische Halbleitervorrichtung kann dieses Material gemäß einem Ausführungsbeispiel umfassen, was einen Mischkristall darstellen kann, der auf technologisch bedeutsamen III-Nitrid-Halbleitern basiert. Hohe remanente Polarisierung, große und lineare Dehnungssausgabe, gute Temperaturstabilität sowie systematisch abstimmbare Koerzitivfelder und Imprint können in dem beispielhaften Fall von Al₁₋ₓScₓN-Dünnfilmen (Beispiel für eine ferroelektrische Speicherschicht) demonstriert werden. Diese Erkenntnisse können einen wertvollen Beitrag zur umfassenderen Implementierung von ferroelektrischer Funktionalität (der ferroelektrischen Speicherschicht mit dem Mischkristall aus dem Material) in mikroelektromechanischen Systemen (MEMS), ICs (integrierten Schaltungen) und Dünnfilmtechnologie im Allgemeinen leisten.

Ferroelektrika weisen eine spontane elektrische Polarisierung mit einer räumlichen Ausrichtung aus, die bei einem angelegten elektrischen Feld geschaltet werden kann. Dies macht sie zu einer eigenständigen Gruppe mit erhöhter Funktionalität unter den piezoelektrischen Materialien. Das Potenzial neuer ferroelektrischer Materialklassen, technologischen Fortschritt erheblich zu beschleunigen, wurde kürzlich anhand der raschen Integration von ferroelektrischen hafniumbasierten Dünnfilmen in beispielsweise nicht flüchtige Feldeffekttransistoren demonstriert [5-7].

Bei einer Wurtzit-Struktur des Mischkristalls, siehe Fig. 9b bis Fig. 9d, (Raumgruppe *P*6₃*mc*) können die III-Nitrid-Halbleiter AIN, GaN und InN eine spontane Polarisierung entlang ihrer c-Achse 960 aufweisen, die ihren Ursprung in der Trennung der Gruppe-III-Atome 111a und Stickstoffatome 111b in einzelnen atomaren Ebenen hat [8]. Daher sind zwei antiparallele Polarisierungsrichtungen vorhanden: N-polar 962, siehe Fig. 9d, und Metall-polar 964, siehe Fig. 9b, (z. B. Ga- oder Al-polar). Fig. 9c zeigt die Wurtzit-Struktur mit einem hexagonalen Schichtaufbau.

Reine Wurtzit-III-Nitride sind pyroelektrische Materialien und nicht ferroelektrisch, da anerkannt ist, dass die Polarisierungsrichtung der reinen Wurtzit-III-Nitride bei elektrischen Feldern unterhalb ihrer individuellen Dielektrischen-Durchschlag-Grenze nicht geschaltet werden kann [2]. Aufgrund der höheren piezoelektrischen Koeffizienten von AIN im Vergleich zu GaN oder InN wird AIN allgemein für piezoelektrische Anwendungen bevorzugt [8]. Akiyama *et al.* haben demonstriert, dass die piezoelektrische Antwort von Mischkristallen, die aus AIN und ScN gebildet sind, mit dem Sc-Gehalt monoton ansteigt, solange die Wurtzit-Struktur beibehalten werden kann [9, 10]. Dies bezieht sich auf das Vorhandensein einer metastabilen geschichteten hexagonalen Phase in ScN [11, 12], die wiederum die lonenpotential-Energielandschaft von z. B. Wurtzit-Al₁₋ₓScₓN abflachen kann. Folglich kann die Wurtzit-Basisebene sowie der interne Parameter u (die Länge der Metall-Stickstoff-Bondverbindung parallel zu der c-Achse) zunehmen, d. h., es kann eine strukturelle Annäherung an die geschichtete hexagonale Phase erfolgen, insbesondere an den Sc-Stellen [11, 13]. Während die geschichtete hexagonale Struktur, siehe Fig. 9c, selbst nicht polar ist, kann dieselbe als Übergangszustand (*u* = ½*c*) zwischen den zwei Polarisierungsausrichtungen der Wurtzit-Struktur betrachtet werden (siehe Fig. 9b und Fig. 9d). Das Vorzeichen der Polarisierung schaltet um, sobald *u* ½*c* passiert. Aufgrund der Abflachung des Ionenpotentials zu der hexagonalen Phase hin ist festgelegt, dass die *u* = ½*c* zugeordnete Energiebarriere sinkt, während der Sc-Gehalt ansteigt. Eine Anpassung einer mechanischen Verspannung der Wurtzit-Basisebene sollte ein weiteres Senken dieser Barriere ermöglichen. Neben der Inkorporation von ScN in AlN, GaN oder InN wurde für andere Metallnitride wie beispielsweise YN oder MgN-NbN vorhergesagt und/oder festgestellt, dass dieselben zu einem ähnlichen Erweichen, einem erhöhten *a-*Gitterparameter und einer verbesserten piezoelektrischen Antwort führen können [12-16]. Der Schlüssel zum ferroelektrischen Schalten bleibt jedoch, dass die Energiebarriere zwischen den zwei Polarisierungszuständen der Wurtzit-Struktur ausreichend gesenkt werden kann - entweder durch Erhöhen des Verhältnisses des Nicht-III-Metalls oder über Anpassung der mechanischen Verspannung, während bis zu einem gewissen Ausmaß der Dielektrische-Durchschlag-Widerstand des reinen III-Nitrids bewahrt wird. Für die Klasse der Gruppe-III-Nitrid basierten Mischkristalle konnte ein so induzierter Übergang zu ferroelektrischem Verhalten bisher noch nicht zuvor beobachtet werden.

In dem beispielhaften Fall von polykristallinen Al₁₋ₓScₓN-Dünnfilmen konnte nicht nur demonstriert werden, dass ferroelektrisches Schalten bei Wurtzit-III-Nitrid-basierten Mischkristallen in der Tat erzielt werden kann - sondern auch, dass das Material faszinierende Eigenschaften aufweist, die für die Kernanwendungen von ferroelektrischen Dünnfilmen bedeutsam sind. Die Filme wurden beispielsweise durch reaktives Sputtern entweder aus einem einzelnen AlSc-Legierungstarget oder durch Ko-Sputtern von separaten AI- und Sc-Targets hergestellt. Die untersuchten Al₁₋ₓScₓN-Schichten zeigten z. B. allgemein eine gute c-Achsenausrichtung senkrecht zu dem Substrat [17], obwohl Körner mit sekundären Ausrichtungen/Phasen für einen Sc-Gehalt mit x ≥ 0,4 beobachtet wurden.

Fig. 9a zeigt ein Diagramm aus dem hervorgeht, dass eine ferroelektrischen Polarisierungsinversion spätestens ab einem Sc-Gehalt von x = 0,27 möglich ist. Unterhalb dessen (bei x = 0,22) können dielektrischer Durchschlag auftreten, bevor das Koerzitivfeld E_{C} vollständig erreicht wurde. P-E(Polarisierung über elektrischem Feld)-Hystereseschleifen von Al₁₋ₓScₓN mit x = 0,27 (910₁); x=0,32 (910₂); 0,36 (910₃); 0,40 (910₄) und 0,43 (910₅) sind in Fig. 9a gegeben. Zum Vergleich ist auch die P-E-Schleife 920 eines PbZr_{0,52}Ti_{0,48}O₃(PZT 52/48)-Films, gemessen mit denselben Parametern, angezeigt. Um (zumindest teilweise) die P-E-Schleifen bezüglich der nicht unerheblichen Leckströme an höheren elektrischen Feldern zu kompensieren, kann eine modifizierte dynamische Leckstromkompensation angewendet werden [18]. Allgemein können sehr große Koerzitivfelder (bis zu 400 V/µm bei x = 0,27), eine nahezu unverminderte Polarisierung zwischen den Koerzitivfeldern und hohe remanente Polarisierungen (110 µC/cm² bei x = 0,27) beobachtet werden. Letztere können erheblich über den theoretischen Berechnungen der spontanen Polarisierung sowohl für reines AIN [8, 19] (≈10 µC/cm²) als auch Al₁₋ₓScₓN [20] (=30 µC/cm² bei x = 0,5) liegen. Darüber hinaus wurde festgestellt, dass das Polarisierungsmaximum mit zunehmendem Sc-Gehalt abnehmen kann, was lediglich teilweise durch die zunehmende Menge von falsch ausgerichteten Körnern zu erklären sein sollte und auch eine Konsequenz eines graduellen Erreichens einer nicht polaren (d. h. geschichtet hexagonalen) Phase sein könnte. Die nahezu ideale kastenförmige Gestalt der Polarisierungshysterese und die großen Koerzitivfelder können auf einer immer noch beträchtlichen Energiebarriere, die der hexagonalen Phase zugeordnet ist, einer guten Zusammensetzungshomogenität und der Wurtzit-Struktur basieren, die lediglich Drehungen im 180°-Bereich zulassen sollte.

Messungen eines direkten und inversen piezoelektrischen Effekts bei ferroelektrischem Al_{0,64}Sc_{0,36}N sind in Fig. 9e bzw. Fig. 9f dargestellt. Beide Richtungen implizieren die Möglichkeit einer praktisch vollständigen Polarisierungsinversion während des ferroelektrischen Schaltens. Für Messungen des direkten piezoelektrischen Effekts auf einer invertierten Probe kann ein einfaches 1-Minuten-Polungsverfahren bei Raumtemperatur verwendet werden, um zwischen den Polarisierungszuständen zu schalten. Bei diesem Verfahren kann der effektive transversale piezoelektrische Koeffizient e_{31,f} von abgeschiedenen -2,90 C/m² zu 2,76 C/m² invertieren, wobei beide Werte für eine AIN-basierte Mischkristalle als hoch gelten können [17, 21]. Wiederholte Messungen der piezoelektrischen Antwort bis zu 30 Wochen nach Polung des invertierten Kondensators zeigten beispielsweise keine Verschlechterung.

Die schmetterlingsförmige Kurve der Längsverschiebung (Fig. 9f) des inversen piezoelektrischen Effekts kann breite lineare Regimes mit nahezu gleichen Neigungen aufweisen, die einem effektiven longitudinalen piezoelektrischen Koeffizienten d_{33,f} von 15,7 pm/V und -16,2 pm/V entsprechen können.

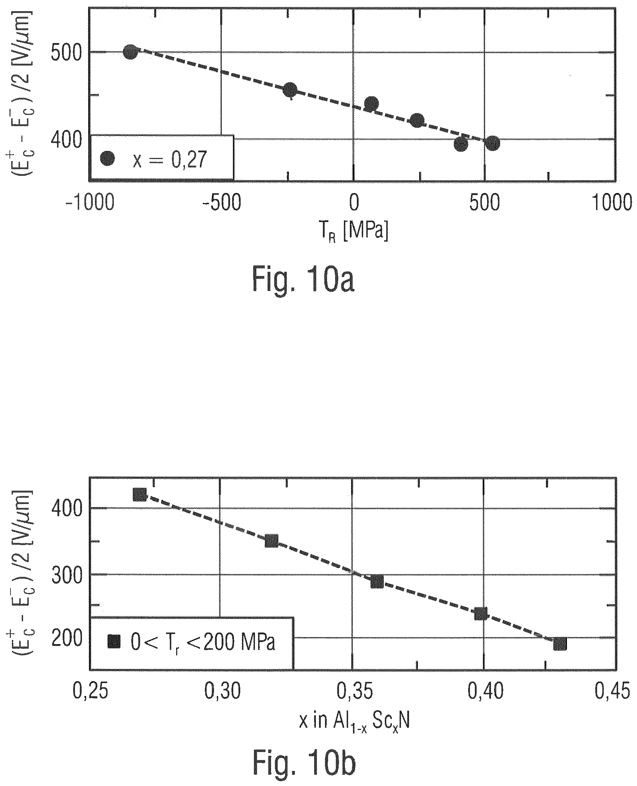

Fig. 10a zeigt ein Diagramm eines mittleren Koerzitivfeldes E_{C} über einer mechanischen Verspannung T_{R} in ferroelektrischen Speicherschichten einer Speicherzelle für eine ferroelektrische Halbleitervorrichtung. Gemäß einem Ausführungsbeispiel kann die ferroelektrische Speicherschicht Al_{0.73}Sc_{0.27}N umfassen, was einer chemischen Verbindung eines Gruppe-III-Nitrids AIN und eines nicht Gruppe-III-Elements Sc entsprechen kann. Zugspannung kann das Koerzitivfeld verringern, Druckspannung kann es erhöhen. Fig. 10b zeigt ein Diagramm eines mittleren Koerzitivfeldes E_{C} über einem Sc Gehalt in ferroelektrischen Speicherschichten, einer Speicherzelle für eine ferroelektrische Halbleitervorrichtung, mit geringer mechanischer Spannung. Ein zunehmender Sc Gehalt kann eine Verringerung des Koerzitivfeldes bewirken. Unter eines Sc Gehalts von x = 0.27 liegt das Koerzitivfeld über der Durchbruchsfeldstärke des Materials und kann daher nicht bestimmt werden. Dies ist gleichbedeutend damit, dass das Material beispielsweise nicht ferroelektrisch ist.

In anderen Worten kann eine Abhängigkeit des mittleren Koerzitivfeldes von der intrinsischen mechanischen Verspannung T_{R}, siehe Fig. 10a, und von dem Sc-Gehalt der Al1-xScxN-Filme, siehe Fig. 10b dargestellt sein. Sc-Gehalt und T_{R} wurden unabhängig variiert.

Ferroelektriztität liegt dann vor, wenn die Polarisation einer Schicht mittels eines externen elektrischen Feldes räumlich umorientiert werden kann. Das mittlere Feld, bei dem diese Umorientierung stattfindet bezeichnet man als Koerzitivfeld. Dieses Koerzitivfeld darf das Durchbruchsfeld des Materials (also das elektrische Feld, bei dem die Schicht schlagartig leitfähig und damit zerstört wird) nicht überschreiten. So ist eine Schicht aus Aluminium-Scandium-Nitrid (Al₁₋ₓScₓN) bei einem Sc Gehalt von x = 0.20 z. B. nicht ferroelektrisch (das Koerzitivfeld liegt oberhalb der Durchbruchsspannung, welche bei AIScN einer Feldstärke von ca. 500V/µm entspricht). Bei einem Sc Gehalt von x = 0.27 ist die Schicht dagegen z. B. bereits ferroelektrisch und ist es auch noch bei einem Sc Gehalt von x = 0.43. Ursache dafür kann sein, dass der zunehmende zusätzliche Metall-Gehalt (nicht Gruppe-III-Element) das Koerzitivfeld reduziert (Fig. 10b). Einen ähnlichen Effekt kann eine mechanische Verspannung der ferroelektrischen Speicherschicht (Fig. 10a) bewirken. Die mechanische Verspannung kann z.B. durch den Abscheideprozess dauerhaft eingeprägt werden.

Der beschriebene Effekt wurde zuvor noch nie für die relevante Materialklasse der Gruppe-III-Nitride beobachtet. Aufgrund der nahezu identischen Materialstruktur von GaN, AIN sowie InN kann von einer allgemeinen Übertragbarkeit der oben vorgestellten experimentellen Ergebnisse ausgegangen werden.

Für zahlreiche Anwendungen von ferroelektrischen Materialien ist die Steuerung von E_{C} von großem Interesse. Während ein großes lineares Regime, d.h. hohe Koerzitivfelder, von Vorteil für Aktuatoranwendungen sein können (um eine harmonische Anregung mit bipolaren Spannungen zu ermöglichen), sollte Ec im Fall von ferroelektrischen ICs z. B. an die gewünscht Schalt-/Schwellenspannung der Schaltung oder die gewünschte Filmdicke angepasst werden. In diesem Zusammenhang kann nicht nur die Breite, sondern auch die Position entlang der Achse des elektrischen Felds (Imprint) der P-E-Schleife von Bedeutung sein.

Die Koerzitivfelder von Al₁₋ₓScₓN und somit die u = 1/2c zugeordnete Energiebarriere kann sowohl anhand des Sc-Gehalts als auch der mechanischen Verspanung T_{R}, die aus dem Abscheidungsvorgang entsteht, systematisch abgestimmt werden, wie in Fig. 10a und Fig. 10b gezeigt ist. Während der Sc-Gehalt durch Variieren des Leistungsverhältnisses zwischen den Targets angepasst werden kann oder durch die Zusammensetzung des Legierungstargets gegeben sein kann, kann die mechanische Verspannung durch Manipulieren des Ar-Flusses in das Sputtergas während des Filmwachstums bestimmt werden [22, 23]. Somit konnten E_{C}-Werte zwischen 190 V/µm (x = 0,43, Tᵣ ≈ 100 MPa) und 500 V/µm (x = 0,27, Tᵣ =-800 MPa) beobachtet werden.

Der Effekt einer planaren mechanischen Verspannung, die aus dem Abscheidungsvorgang auf E_{C} entstehen kann, könnte sich durch ihre Auswirkung auf die Basisebene der Wurtzit-Elementarzelle eines Mischkristalls der ferroelektrischen Speicherschicht erklären lassen: Zugspannung sollte den Gitterparameter a in einem Korn mit zum Substrat senkrechter c-Achse erhöhen, während Druckspannung den gegenteiligen Effekt bewirken sollte. Es wird deshalb erwartet, dass eine ähnliche Auswirkung auf die Energiebarriere auftritt wie eine epitaktische Dehnung [13]. Im Bereich der untersuchten Verspannung und der Sc-Zusammensetzung wurde festgestellt, dass E_{C} nahezu linear von den untersuchten Parameter abhängen kann.

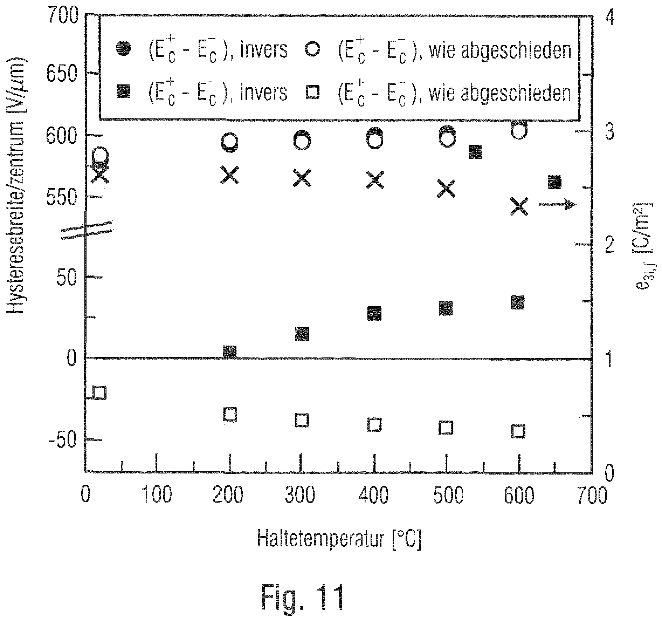

Fig. 11 zeigt ein Diagramm von Breite und Mitte von P-E-Schleifen auf abgeschiedenen und invertierten Al_{0,64}Sc_{0,36}N-Kondensatoren sowie e_{31,f} eines invertierten Kondensators nach Temperaturbehandlung (rechte Achse). Fig. 11 kann einen transversalen piezoelektrischen Koeffizientn e_{31,f} einer Al_{0.64}Sc_{0.36}N-Probe nach jeweils 5-minütiger Temperaturbehandlung bei bis zu 600°C darstellen. Die Tatsache, dass sich der Betrag des piezoelektrischen Koeffizienten nur unwesentlich ändert, kann bedeuten, dass auch die spontane Polarisation des Materials bei über 600°C im Wesentlichen erhalten bleibt.

Die abgeschiedenen und polarisations-invertierbaren Al_{0,64}Sc_{0,36}N-Kondensatoren können ein Beispiel für eine Speicherzelle bestehend aus einer ersten leitfähigen Schicht, einer zweiten leitfähigen Schicht und einer ferroelektrischen Speicherschicht sein, wobei die Schichten in dieser Reihenfolge angeordnet sind und die ferroelektrische Speicherschicht ein Gruppe-III-Nitrid AIN und ein nicht Gruppe-III-Element Sc aufweist.

Es konnte gezeigt werden, dass relevante ferroelektrische Eigenschaften (insb. eine eingestellte Polarisation) auch bei Temperaturen von über 600°C erhalten bleiben können. Dies ist eine deutliche Verbesserung gegenüber Hafnium-Oxid basierten Verbindungen, wo bereits bei 300°C eine deutliche Abschwächung der Polarisation beobachtet werden kann. Genauso bleibt die Polarisation der ferroelektrischen Speicherschicht auch über einen langen Zeitraum (6 Monate) ohne messbare Abschwächung erhalten. Dies ist eine deutliche Verbesserung gegenüber Hafnium-Oxid basierten Verbindungen und insbesondere gegenüber klassischen Perovskiten [34].

Da Informationen in einer ferroelektrischen Speicherzelle direkt in der elektrischen Polarisation gespeichert werden können, lassen sich die oben beschrieben Vorteile direkt auf ein solches Speicherlement übertragen. Die gespeicherte Information bliebe über einen langen Zeitraum, auch bei sehr hoher Temperatur, zuverlässig erhalten.

Abgeschiedene Al₁₋ₓScₓN-Filme können einen Polarisierungsimprint zwischen -20 und -30 V/µm zeigen. Zum Steuern des Imprint-Pegels und damit der Mitte der P-E-Hysterese erwies sich eine Temperaturbehandlung als möglich (Fig. 11). Das Durchführen einer derartigen Behandlung von bis zu 600 °C auf einem Kondensator mit invertierter Polarisierung kann zu einer deutlichen Zunahme und einem Vorzeichenwechsel des Imprintfelds führen. Auf einem abgeschiedenen Kondensator kann das Imprintfeld kleiner werden, wenn auch mit einer niedrigeren Rate. Die Gesamtbreite der P-E-Schleife nahm z. B. nur leicht zu. Dies legt nahe, dass der Polarisierungsimprint in Al₁₋ₓScₓN defektbezogen sein könnte, und eine langsame, thermisch induzierte Neuanordnung dieser geladenen Defekte gemäß dem Polarisierungszustand der Kondensatoren verwendet werden kann, um den Imprint zu modifizieren - analog zu dem, was bei ferroelektrischen Perovskiten beobachtet wurde [24]. Es ist deshalb möglich, sowohl die Spanne als auch das Zentrum der Al₁₋ₓScₓN-Polarisierungshysterese systematisch durch Gitterdehnung, Hinzufügen von ScN sowie thermisch induziertem Polarisierungsimprint zu modifizieren. Angesichts des breiten Spektrums von Dicken, in denen Filme aus reinem AIN mit guter c-Achsenausrichtung (bis unterhalb 10 nm) gezüchtet werden können (Fig. 3) [25], bietet die hierin beschriebene Erfindung ein hohes Maß an Flexibilität hinsichtlich eines Anpassens der Schaltspannung auf eine spezifische Anwendung.

Darüber hinaus kann eine Polarisierungsinversion über den gesamten Temperaturbereich hinweg erhalten werden: e_{31,f} nahm z. B. während der Temperaturbehandlungsschritte nur geringfügig ab (Fig. 11). Folglich können 600 °C als Untergrenze für die paraelektrische Übergangstemperatur von Al_{0,64}Sc_{0,36}N betrachtet werden. Über 600 °C hinaus kann eine Verschlechterung der Elektroden eine weitere elektrische Charakterisierung der Kondensatoren verhindern.

Es wird davon ausgegangen, dass dieses Material (AIScN) nur das erste einer neuartigen Klasse von ferroelektrischen Wurtzit-III-Nitrid-basierten Mischkristalle ist, wobei wahrscheinliche weitere Kandidaten für diese Klasse beispielsweise Ga₁₋ₓScₓN, Al₁₋ₓYₓN oder Al_{1-x-y}MgₓNb_{y}N sind.

Vom Anwendungsstandpunkt aus könnte die ungewöhnliche Kombination aus einem großen linearen Bereich und einer stabilen Polarisierungssteuerung durch ferroelektrisches Schalten beispielsweise Vorteile bei der Anwendung von piezoelektrischen Mehrschichtdünnfilmen für eine MEMS-Betätigung, Erfassung und Harvesting bei minimaler Anzahl von Trägerschichten und der Möglichkeit einer bipolaren Anregung ermöglichen. Darüber hinaus sind die Basismaterialien CMOS-kompatibel und im Fall von AIN und GaN in Reinräumen bereits gut etabliert, was der hierin beschriebenen Erfindung im Kontext nicht flüchtiger (Hochtemperatur-)ICs Relevanz verleiht.

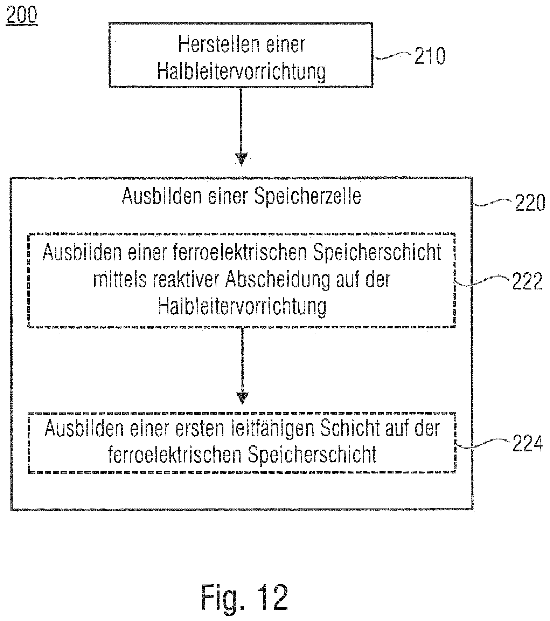

Fig. 12 zeigt ein Blockdiagramm eines Verfahrens 200 zur Herstellung einer ferroelektrischen Halbleitervorrichtung. Das Verfahren 200 umfasst z. B. ein Herstellen 210 einer Halbleitervorrichtung und ein Ausbilden 220 einer Speicherzelle mit einer ferroelektrischen Speicherschicht und einer ersten leitfähigen Schicht, die an der ferroelektrischen Speicherschicht angeordnet sein kann. Die ferroelektrische Speicherschicht der Speicherzelle kann einen Mischkristall mit einem Gruppe-III-Nitrid und einem nicht Gruppe-III-Element aufweisen. Die Speicherzelle kann mit der Halbleitervorrichtung verbunden werden.

Optional kann das Ausbilden 220 der Speicherzelle ein Ausbilden 222 der ferroelektrischen Speicherschicht mittels reaktiver Abscheidung auf der Halbleitervorrichtung und ein Ausbilden 224 der ersten leitfähigen Schicht auf der ferroelektrischen Speicherschicht aufweisen.

Gemäß einem Ausführungsbeispiel kann das Ausbilden 220 der Speicherzelle ein Ausbilden einer isolierenden Schicht auf der Halbleitervorrichtung, ein Ausbilden der ferroelektrischen Speicherschicht mittels reaktiver Abscheidung auf der isolierenden Schicht und ein Ausbilden 224 der ersten leitfähigen Schicht auf der ferroelektrischen Speicherschicht aufweisen.

Gemäß einem Ausführungsbeispiel kann das Ausbilden 220 der Speicherzelle ein Ausbilden einer isolierenden Schicht auf der Halbleitervorrichtung, ein Ausbilden einer zweiten leitfähigen Schicht auf der isolierenden Schicht, ein Ausbilden der ferroelektrischen Speicherschicht mittels reaktiver Abscheidung auf der zweiten leitfähigen Schicht und ein Ausbilden 224 der ersten leitfähigen Schicht auf der ferroelektrischen Speicherschicht aufweisen.

Optional können zwischen der ferroelektrischen Speicherschicht und der Halbleitervorrichtung zumindest drei Zwischenschichten in dem Schritt Ausbilden 220 der Speicherzelle ausgebildet werden. Zwischenschichten können Merkmale und Funktionalitäten, wie die erste leitfähige Schicht, die zweite leitfähige Schicht, die isolierende Schicht und/oder die ferroelektrische Speicherschicht aufweisen.

Für die Funktion der ferroelektrischen Halbleitervorrichtung ist es vorteilhaft, dass die erste leitfähige Schicht beispielsweise auf einer abgewandten Seite bzgl. des Halbleiterbauelements angeordnet ist (also z. B. das die ferroelektrische Speicherschicht zwischen der ersten leitfähigen Schicht und der Halbleitervorrichtung angeordnet ist). Somit kann die Herstellung des Halbleiterelements zuerst erfolgen und darauf können dann optional weitere Schichten aufgebracht/ausgebildet werden, wie Isolatoren bzw. Elektroden (z. B. die isolierende Schicht, die zweite leitfähige Schicht, Zwischenschichten, etc.) und schließlich das Ferroelektrikum. Die als erste leitfähige Schicht bezeichnete Elektrode kann somit z. B. als letztes abgeschieden werden.

Gemäß einem Ausführungsbeispiel kann es sich bei dem Gruppe-III-Nitrid um AIN und bei dem nicht-Gruppe-III-Nitrid um Sc handeln. Somit kann die ferroelektrische Speicherschicht auch als Al₁₋ₓScₓN-Film bezeichnet werden (x kann eine Zahl zwischen 0 und 1 sein). Die ferroelektrische Speicherschicht kann durch reaktive Sputterabscheidung auf oxidierten 200-mm(100)-Si-Wafern, die mit einer AlN/Pt-Bodenelektrode (Beispiel für die erste leitfähige Schicht) bedeckt sind, hergestellt werden. Vorgangsparameter für die Al₁₋ₓScₓN-Filme, die von dualen Targets abgeschieden werden können (alle außer Al_{0,64}Sc_{0,36}N), können [17] entnommen werden. Al_{0,64}Sc_{0,36}N kann von einem einzelnen Legierungs-AlSc-Target mit einem nominalen Sc-Gehalt von 43 at-% und einer Reinheit von 99,9 at-% abgeschieden werden. Die Leistung kann auf 600 W eingestellt werden, ein Gas kann mit bis zu 7,5 sccm Ar und 15 sccm N₂ in die Kammer strömen, wobei ein Substrat (z. B. der oxidierte 200-mm(100)-Si-Wafer mit einer AlN/Pt-Bodenelektrode) während der Abscheidung bei 400 °C z. B. gehalten wird. Eine Filmdicke der ferroelektrischen Speicherschicht kann auf 400 nm (alle Filme mit x = 0,27), 600 nm (x = 0,32; 0,36; 0,40 und PZT) oder 1 µm (x = 0,43) eingestellt werden. PZT-Filme können über Sol-Gel-Abscheidung mit zuvor veröffentlichten Vorgangsdetails erhalten [26] erhalten werden.

Alle hierin aufgeführten Aufzählungen der Materialien für die Speicherzelle und die Halbleitervorrichtung, Ausgestaltungen der Speicherzelle und Ausgestaltungen der Halbleitervorrichtungen sind hierbei als beispielhaft und nicht als abschließend anzusehen.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hard-ware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

### Patentliteratur

[1] Setter, N. et al. Ferroelectric thin films: Review of materials, properties, and applications. J. Appl. Phys. 100, 051606 (2006).
[2] Muralt, P., Polcawich, R. G. & Trolier-Mckinstry, S. Piezoelectric Thin Films for Sensors, Actuators, and Energy Harvesting. MRS Bull. 35, 658-664 (2009).
[3] Dawber, M., Rabe, K. M. & Scott, J. F. Physics of thin-film ferroelectric oxides.Review of Modern Physics 77, 1083-1130 (2005).
[4] Zhang, S., Xia, R., Lebrun, L., Anderson, D. & Shrout, T. R. Piezoelectric materials for high power, high temperature applications. Mater. Lett. 59, 3471-3475 (2005).
[5] Böscke, T. S., Müller, J., Bräuhaus, D., Schröder, U. & Böttger, U. Ferroelectricity in hafnium oxide thin films. Appl. Phys. Lett. 99, 102903 (2011).
[6] Martin, D. et al. Ferroelectricity in Si-Doped HfO2 revealed: A binary lead-free ferroelectric. Adv. Mater. 26, 8198-8202 (2014).
[7] Müller, J. & et al. Ferroelectric hafnium oxide: A CMOS-compatible and highly scalable approach to future ferroelectric memories. 2013 IEEE Int. Electron Devices Meet. 10.8.1-10.8.4 (2013).
[8] Bernardini, F., Fiorentini, V. & Vanderbilt, D. Spontaneous polarization and piezoelectric constants of III-V nitrides. Phys. Rev. B 56, 24-27 (1997).
[9] Akiyama, M. et al. Enhancement of piezoelectric response in scandium aluminum nitride alloy thin films prepared by dual reactive cosputtering. Adv. Mater. 21, 593-596 (2009).
[10] Akiyama, M., Kano, K. & Teshigahara, A. Influence of growth temperature and scandium concentration on piezoelectric response of scandium aluminum nitride alloy thin films. Appl. Phys. Lett. 95, 162107 (2009).
[11] Tasnadi, F. et al. Origin of the anomalous piezoelectric response in wurtzite Scx-Al1-xN alloys. Phys. Rev. Lett. 104, 137601 (2010).
[12] Farrer, N. & Bellaiche, L. Properties of hexagonal ScN versus wurtzite GaN and InN. Phys. Rev. B 66, 201203 (2002).
[13] Zhang, S., Holec, D., Fu, W. Y., Humphreys, C. J. & Moram, M. A. Tunable optoelectronic and ferroelectric properties in Sc-based III-nitrides. J. Appl. Phys. 114, 133510 (2013).
[14] Tholander, C. et al. Ab initio calculations and experimental study of piezoelectric YxIn1-xN thin films deposited using reactive magnetron sputter epitaxy. Acta Mater. 105, 199-206 (2016).
[15] Mayrhofer, P. M. et al. Microstructure and piezoelectric response of YxAl1-xN thin films. Acta Mater. 100, 81-89 (2015).
[16] Uehara, M. et al. Giant increase in piezoelectric coefficient of AlN by Mg-Nb simultaneous addition and multiple chemical states of Nb. Appl. Phys. Lett. 111, 112901 (2017).
[17] Fichtner, S. et al. Identifying and overcoming the interface originating c-axis instability in highly Sc enhanced AIN for piezoelectric micro-electromechanical systems. J. Appl. Phys. 122, 035301 (2017).
[18] Meyer, R., Waser, R., Prume, K., Schmitz, T. & Tiedke, S. Dynamic leakage current compensation in ferroelectric thin-film capacitor structures. Appl. Phys. Lett. 86, 142907 (2005).
[19] Ambacher, O. et al. Two-dimensional electron gases induced by spontaneous and piezoelectric polarization charges in N- and Ga-face AlGaN/GaN heterostructures. J. Appl. Phys. 85, 3222 (1999).
[20] Caro, M. et al. Piezoelectric coefficients and spontaneous polarization of ScAlN. J. Phys. Condens. Matter 27, 245901 (2015).
[21] Mertin, S. et al. Piezoelectric and structural properties of c-axis textured aluminium scandium nitride thin films up to high scandium content. Surf. Coatings Technol. 343, 2-6 (2018).
[22] Dubois, M.-A. & Muralt, P. Stress and piezoelectric properties of aluminum nitride thin films deposited onto metal electrodes by pulsed direct current reactive sputtering. J. Appl. Phys. 89, 6389 (2001)
[23] Fichtner, S., Reimer, T., Chemnitz, S., Lofink, F. & Wagner, B. Stress controlled pulsed direct current co-sputtered Al1-xScxN as piezoelectric phase for micromechanical sensor applications. APL Mater. 3, 116102 (2015).
[24] Warren, W. L. et al. Voltage shifts and imprint in ferroelectric capacitors. Appl. Phys. Lett. 67, 866 (1996).
[25] Zaghloul, U. & Piazza, G. Synthesis and characterization of 10nm thick piezoelectric AIN films with high c-axis orientation for miniaturized nanoelectromechanical devices. Appl. Phys. Lett. 104, 253101 (2014)
[26] Piorra, A. et al. Magnetoelectric thin film composites with interdigital electrodes. Appl. Phys. Lett. 103, 032902 (2013).
[27] Prume, K., Muralt, P., Calame, F., Schmitz-Kempen, T. & Tiedke, S. Piezoelectric Thin Films: Evaluation of Electrical and Electromechanical Characteristics for MEMS Devices. IEEE Trans. Ultrason. Ferroelectr. Freq. Control 54, 8-14 (2007).
[28] Gerber, P. et al. Short-time piezoelectric measurements in ferroelectric thin films using a double-beam laser interferometer. Rev. Sci. Instrum. 74, 2613-2615 (2003).
[29] Sivaramakrishnan, S., Mardilovich, P., Schmitz-Kempen, T. & Tiedke, S. Concurrent wafer-level measurement of longitudinal and transverse effective piezoelectric coefficients (d33,f and e31,f) by double beam laser interferometry. J. Appl. Phys. 123, 014103 (2018).
[30] Janssen, G. C. A. M., Abdalla, M. M., van Keulen, F., Pujada, B. R. & van Venrooy, B. Celebrating the 100th anniversary of the Stoney equation for film stress: Developments from polycrystalline steel strips to single crystal silicon wafers. Thin Solid Films 517, 1858-1867 (2009).
[31] J. F. Scott, Ferroelectric Memories, Springer Heidelberg, 2000.
[32] T. Böscke, J. Müller, D. Bräuhaus, U. Schröder, U. Böttger, Appl. Phys. Lett. 2011, 99, 102903.
[33] T. Böscke, Integrated Circuit Including a Ferroelectric Memory Cell and Method of Manufacturing the Same, 2009, US 8,304,823 B2.
[34] T. Shimizu, K. Katayama, T. Kiguchi, A. Akama, T. J. Konno, O. Sakata, H. Funakubo, Sci. Rep. 2016, 6, 1.
[35] J. Müller, P. Polakowski, S. Mueller, T. Mikalajick, ECS J. Solid State Sci. Tech., 2015, 4, N30
[36] US9449972 (B1)

## Patentansprüche

1. Ferroelektrische Halbleitervorrichtung (100) mit folgenden Merkmalen:
einer Speicherzelle (110) mit einer ferroelektrischen Speicherschicht (112) und einer ersten leitfähigen Schicht (114), die an der ferroelektrischen Speicherschicht (112) angeordnet ist; und
eine Halbleitervorrichtung (120), die mit der Speicherzelle (110) verbunden ist,
wobei die ferroelektrische Speicherschicht (112) der Speicherzelle (110) einen Mischkristall (112a) mit mindestens einem Gruppe-III Nitrid (111, 111a, 111b) und mindestens einem nicht Gruppe-III Element (113) aufweist,
wobei die nicht Gruppe-III Elemente (113) 20-50% der Plätze von Gruppe-III Atomen (111a) der Gruppe-III Nitride (111, 111a, 111b) innerhalb des Mischkristalls (112a) besetzen.

2. Ferroelektrische Halbleitervorrichtung (100) gemäß Anspruch 1, wobei die Speicherzelle (110) eine isolierende Schicht (116), die ferroelektrische Speicherschicht (112) und die erste leitfähige Schicht (114) aufweist, die in dieser Reihenfolge angeordnet sind; oder
wobei die Speicherzelle (110) eine zweite leitfähige Schicht (118), die ferroelektrische Speicherschicht (112) und die erste leitfähige Schicht (114) aufweist, die in dieser Reihenfolge angeordnet sind; oder
wobei die Speicherzelle (110) eine isolierende Schicht (116), eine zweite leifähige Schicht (118), die ferroelektrische Speicherschicht (112) und die erste leitfähige Schicht (114) aufweist, die in dieser Reihenfolge angeordnet sind.

3. Ferroelektrische Halbleitervorrichtung (100) gemäß Anspruch 2, wobei die ferroelektrische Speicherschicht (112) eine geringere Ausdehnung parallel zu einer Oberfläche der ersten leitfähigen Schicht (114) aufweist, als die isolierende Schicht (116) und/oder die zweite leitfähige Schicht.

4. Ferroelektrische Halbleitervorrichtung (100) gemäß einem der Ansprüche 1 bis 3, wobei die Speicherzelle (110) eine u-Form, eine o-Form, eine zylindrische Form oder eine Quaderform aufweist.

5. Ferroelektrische Halbleitervorrichtung (100) gemäß einem der Ansprüche 1 bis 4, wobei das Gruppe-III Nitrid (111, 111a, 111b) des Mischkristalls (112a) der ferroelektrischen Speicherschicht (112) AIN, GaN, InN oder eine Kombination dieser aufweist.

6. Ferroelektrische Halbleitervorrichtung (100) gemäß einem der Ansprüche 1 bis 5, wobei das nicht Gruppe-III Element (113) ein Übergangmetall oder Mg aufweist.

7. Ferroelektrische Halbleitervorrichtung (100) gemäß einem der Ansprüche 1 bis 6, wobei die Halbleitervorrichtung (120) einen FeFET umfasst und die Speicherzelle (110) zumindest einen Teil einer Gatestruktur der Halbleitervorrichtung (120) bildet.

8. Ferroelektrische Halbleitervorrichtung (100) gemäß Anspruch 7, wobei der FeFET ein planarer MOSFET, ein FinFET oder ein HEMT ist.

9. Ferroelektrische Halbleitervorrichtung (100) gemäß einem der Ansprüche 1 bis 8, wobei die Speicherzelle (110) ausgelegt ist, um die Halbleitervorrichtung (120) basierend auf einer in der Speicherzelle (110) gespeicherten Information zu steuern.

10. Ferroelektrische Halbleitervorrichtung (100) gemäß Anspruch 9, wobei die Speicherzelle (110) ausgelegt ist, um die Halbleitervorrichtung (120) basierend auf der in der Speicherzelle (110) gespeicherten Information entweder in einen An-Zustand oder in einen Aus-Zustand zu versetzten.

11. Ferroelektrische Halbleitervorrichtung (100) gemäß Anspruch 10, wobei die Halbleitervorrichtung (120) in dem An-Zustand eine Leitfähigkeit größer oder gleich einer oberen Schwelle aufweist und in dem Aus-Zustand eine Leitfähigkeit kleiner oder gleich einer unteren Schwelle aufweist.

12. Ferroelektrische Halbleitervorrichtung (100) gemäß einem der Ansprüche 1 bis 6, wobei die Halbleitervorrichtung (120) einen FeRAM umfasst und die Speicherzelle (110) zumindest einen Teil einer Kondensatorstruktur oder einer Gatestruktur der Halbleitervorrichtung (120) bildet.

13. Integrierte Schaltung mit einer ferroelektrischen Halbleitervorrichtung (100) nach einem der Ansprüche 1 bis 12.

14. Verfahren (200) zur Herstellung einer ferroelektrischen Halbleitervorrichtung (100), mit folgenden Schritten:
Herstellen (210) einer Halbleitervorrichtung (120) und
Ausbilden (220) einer Speicherzelle mit einer ferroelektrischen Speicherschicht (112) und einer ersten leitfähigen Schicht (114), die an der ferroelektrischen Speicherschicht (112) angeordnet ist;
wobei die ferroelektrische Speicherschicht (112) der Speicherzelle (110) einen Mischkristall (112a) mit einem Gruppe-III Nitrid (111, 111a, 111b) und einem nicht Gruppe-III Element (113) aufweist; und
wobei die nicht Gruppe-III Elemente (113) 20-50% der Plätze von Gruppe-III Atomen (111a) der Gruppe-III Nitride (111, 111a, 111b) innerhalb des Mischkristalls (112a) besetzen.

15. Verfahren (200) gemäß Anspruch 14, wobei das Ausbilden der Speicherzelle folgende Schritte aufweist:
Ausbilden (222) der ferroelektrischen Speicherschicht (112) mittels reaktiver Abscheidung auf der Halbleitervorrichtung (120) und
Ausbilden (224) der ersten leitfähigen Schicht (114) auf der ferroelektrischen Speicherschicht (112).

## Claims

1. Ferroelectric semiconductor device (100), comprising:
a memory cell (110) with a ferroelectric memory layer (112) and a first conductive layer (114) disposed on the ferroelectric memory layer (112); and
a semiconductor device (120) connected to the memory cell (110),
wherein the ferroelectric memory layer (112) of the memory cell (110) comprises a mixed crystal (112a) with at least one group III nitride (111, 111a, 111b) and at least one non-group III element (113),
wherein the non-group III elements (113) occupy 20 to 50 % of the spaces of group III atoms (111a) of the group III nitrides (111, 111a, 111b) within the mixed crystal (112a).

2. Ferroelectric semiconductor device (100) according to claim 1, wherein the memory cell (110) comprises an insulating layer (116), the ferroelectric memory layer (112) and the first conductive layer (114) that are disposed in that order; or
wherein the memory cell (110) comprises a second conductive layer (118), the ferroelectric memory layer (112) and the first conductive layer (114) that are disposed in that order; or
wherein the memory cell (110) comprises an insulating layer (116), a second conductive layer (118), the ferroelectric memory layer (112) and the first conductive layer (114) that are disposed in this order.

3. Ferroelectric semiconductor device (100) according to claim 2, wherein the ferroelectric memory layer (112) has a more limited extension parallel to a surface of the first conductive layer (114) than the insulating layer (116) and/or the second conductive layer.

4. Ferroelectric semiconductor device (100) according to one of claims 1 to 3, wherein the memory cell (110) has a U shape, an O shape, a cylindrical shape or a cuboid shape.

5. Ferroelectric semiconductor device (100) according to one of claims 1 to 4, wherein the group III nitride (111, 111a, 111b) of the mixed crystal (112a) of the ferroelectric memory layer (112) comprises AIN, GaN, InN or a combination thereof.

6. Ferroelectric semiconductor device (100) according to one of claims 1 to 5, wherein the non-group III element (113) comprises a transition metal or Mg.

7. Ferroelectric semiconductor device (100) according to one of claims 1 to 6, wherein the semiconductor device (120) includes an FeFET and the memory cell (110) forms at least part of a gate structure of the semiconductor device (120).

8. Ferroelectric semiconductor device (100) according to claim 7, wherein the FeFET is a planar MOSFET, a FinFET or an HEMT.

9. Ferroelectric semiconductor device (100) according to one of claims 1 to 8, wherein the memory cell (110) is configured to control the semiconductor device (120) based on information stored in the memory cell (110).

10. Ferroelectric semiconductor device (100) according to claim 9, wherein the memory cell (110) is configured to put the semiconductor device (120) either into an on-state or an off-state, based on information stored in the memory cell (110).

11. Ferroelectric semiconductor device (100) according to claim 10, wherein, in the on-state, the semiconductor device (120) has a conductivity of more than or equal to an upper threshold, and in the off-state, the same has a conductivity of less than or equal to a bottom threshold.

12. Ferroelectric semiconductor device (100) according to one of claims 1 to 6, wherein the semiconductor device (120) includes an FeRAM and the memory cell (110) forms at least part of a capacitor structure or a gate structure of the semiconductor device (120).

13. Integrated circuit with a ferroelectric semiconductor device (100) according to one of claims 1 to 12.

14. Method (200) for producing a ferroelectric semiconductor device (100), comprising:
producing (210) a semiconductor device (120) and
forming (220) a memory cell with a ferroelectric memory layer (112) and a first conductive layer (114) that is disposed on the ferroelectric memory layer (112);
wherein the ferroelectric memory layer (112) of the memory cell (110) comprises a mixed crystal (112a) with a group III nitride (111, 111a, 111b) and a non-group III element (113); and
wherein the non-group III elements (113) occupy 20 to 50 % of the spaces of group III atoms (111a) of the group III nitrides (111, 111a, 111b) within the mixed crystal (112a).

15. Method (200) according to claim 14, wherein forming the memory cell comprises:
forming (222) the ferroelectric memory layer (112) by means of reactive deposition on the semiconductor device (120) and
forming (224) the first conductive layer (114) on the ferroelectric memory layer (112).

## Revendications

1. Dispositif à semi-conducteur ferroélectrique (100) aux caractéristiques suivantes:
une cellule de mémoire (110) avec une couche de mémoire ferroélectrique (112) et une première couche conductrice (114) qui est disposée sur la couche de mémoire ferroélectrique (112); et
un dispositif à semi-conducteur (120) qui est connecté à la cellule de mémoire (110),
dans lequel la couche de mémoire ferroélectrique (112) de la cellule de mémoire (110) présente un cristal mixte (112a) avec au moins un nitrure du groupe III (111, 111a, 111b) et au moins un élément autre que du groupe III (113),
dans lequel les éléments autres que du groupe III (113) occupent de 20 à 50 % des emplacements des atomes du groupe III (111a) des nitrures du groupe III (111, 111a, 111b) dans le cristal mixte (112a).

2. Dispositif à semi-conducteur ferroélectrique (100) selon la revendication 1, dans lequel la cellule de mémoire (110) présente une couche isolante (116), la couche de mémoire ferroélectrique (112) et la première couche conductrice (114) qui sont disposées dans cet ordre; ou
dans lequel la cellule de mémoire (110) présente une deuxième couche conductrice (118), la couche de mémoire ferroélectrique (112) et la première couche conductrice (114) qui sont disposées dans cet ordre; ou
dans lequel la cellule de mémoire (110) présente une couche isolante (116), une deuxième couche conductrice (118), la couche de mémoire ferroélectrique (112) et la première couche conductrice (114) qui sont disposées dans cet ordre.

3. Dispositif à semi-conducteur ferroélectrique (100) selon la revendication 2, dans lequel la couche de mémoire ferroélectrique (112) présente une extension plus réduite parallèle à une surface de la première couche conductrice (114) que la couche isolante (116) et/ou la deuxième couche conductrice.

4. Dispositif à semi-conducteur ferroélectrique (100) selon l'une des revendications 1 à 3, dans lequel la cellule de mémoire (110) présente une forme en "U", une forme en "O", une forme cylindrique ou une forme de parallélépipède.

5. Dispositif à semi-conducteur ferroélectrique (100) selon l'une des revendications 1 à 4, dans lequel le nitrure du groupe III (111, 111a, 111b) du cristal mixte (112a) de la couche de mémoire ferroélectrique (112) présente de l'AlN, du GaN, de l'InN ou une combinaison de ces derniers.

6. Dispositif à semi-conducteur ferroélectrique (100) selon l'une des revendications 1 à 5, dans lequel l'élément autre que du groupe III (113) présente un métal de transition ou du Mg.

7. Dispositif à semi-conducteur ferroélectrique (100) selon l'une des revendications 1 à 6, dans lequel le dispositif à semi-conducteur (120) comporte un FeFET et la cellule de mémoire (110) constitue au moins une partie d'une structure de grille du dispositif à semi-conducteur (120).

8. Dispositif à semi-conducteur ferroélectrique (100) selon la revendication 7, dans lequel le FeFET est un MOSFET planaire, un FinFET ou un HEMT.

9. Dispositif à semi-conducteur ferroélectrique (100) selon l'une des revendications 1 à 8, dans lequel la cellule de mémoire (110) est conçue pour commander le dispositif à semi-conducteur (120) sur base d'une information mémorisée dans la cellule de mémoire (110) .

10. Dispositif à semi-conducteur ferroélectrique (100) selon la revendication 9, dans lequel la cellule de mémoire (110) est conçue pour commuter le dispositif à semi-conducteur (120), sur base des informations mémorisées dans la cellule de mémoire (110) soit à un état activé, soit à un état désactivé.

11. Dispositif à semi-conducteur ferroélectrique (100) selon la revendication 10, dans lequel le dispositif à semi-conducteur (120) présente, à l'état activé, une conductivité supérieure ou égale à un seuil supérieur et, à l'état désactivé, une conductivité inférieure ou égale à un seuil inférieur.

12. Dispositif à semi-conducteur ferroélectrique (100) selon l'une des revendications 1 à 6, dans lequel le dispositif à semi-conducteur (120) comporte une FeRAM et la cellule de mémoire (110) constitue au moins une partie d'une structure de condensateur ou d'une structure de grille du dispositif à semi-conducteur (120).

13. Circuit intégré avec un dispositif à semi-conducteur ferroélectrique (100) selon l'une des revendications 1 à 12.

14. Procédé (200) de fabrication d'un dispositif à semi-conducteur ferroélectrique (100), aux étapes suivantes consistant à:
fabriquer (210) un dispositif à semi-conducteur (120), et
former (220) une cellule de mémoire avec une couche de mémoire ferroélectrique (112) et une première couche conductrice (114) qui est disposée sur la couche de mémoire ferroélectrique (112);
dans lequel la couche de mémoire ferroélectrique (112) de la cellule de mémoire (110) comprend un cristal mixte (112a) avec un nitrure du groupe III (111, 111a, 111b) et un élément autre que du groupe III (113); et
dans lequel les éléments autres que du groupe III (113) occupent de 20 à 50 % des emplacements des atomes du groupe III (111a) des nitrures du groupe III (111, 111a, 111b) dans le cristal mixte (112a).

15. Procédé (200) selon la revendication 14, dans lequel la formation de la cellule de mémoire présente les étapes suivantes consistant à:
former (222) la couche de mémoire ferroélectrique (112) au moyen du dépôt réactif sur le dispositif à semi-conducteur (120), et
former (224) la première couche conductrice (114) sur la couche de mémoire ferroélectrique (112).
